# EUROPÄISCHE PATENTSCHRIFT

(11) **EP 2 400 822 B1**
(45) Veröffentlichungstag und Bekanntmachung des Hinweises auf die Patenterteilung: **18.03.2015**
(21) Anmeldenummer: 11171802.9
(22) Anmeldetag: 28.06.2011
(51) Int. Cl.: H05K 1/14, F21K 99/00

(54) **Elektronisches Bauelement**
Electronic component
Composant électronique

(30) Priorität: 28.06.2010 DE 102010025315
(43) Veröffentlichungstag der Anmeldung: 28.12.2011
(73) Patentinhaber: Spyrelight Gmbh, 80797 München (DE)
(72) Erfinder: Orkin, Evgeny, 81476 München (DE); Huebner, Manuel, 81539 München (DE); Biberacher, Lukas, 85411 Hohenkammer (DE)
(74) Vertreter: Vossius & Partner

(56) Entgegenhaltungen:
- EP-A1- 1 548 573
- EP-A2- 1 945 015
- GB-A- 2 143 985
- JP-A- 2 278 282
- US-A1- 2008 245 949
- US-A1- 2009 065 797

## Beschreibung

Die vorliegende Erfindung betrifft ein elektronisches Bauelement, insbesondere eine Leiterplatte, mit einem Trägermaterial, das Befestigungsbereiche für Leuchtmittel und bevorzugt für Leuchtdioden (LED) aufweist, die über erste und zweite Leiterbahnen mit einem Anschlussbereich zur Stromversorgung und/oder Steuerung verbindbar sind.

Derartige elektronische Bauelemente sind bekannt. So betrifft die DE 10 2006 033 894 A1 eine Beleuchtungseinrichtung mit mindestens einem Lichtmodul, dass eine Leiterplatte und eine Mehrzahl von Lichtquellen aufweist, wobei die Lichtquellen in Gruppen aufgebracht sind. Die Lichtmodule der beschriebenen Beleuchtungseinrichtung sind streifenförmig ausgebildet, wobei die Lichtquellen eindimensional hintereinander angeordnet sind. Derartige Streifen von Lichtmodulen sind parallel zueinander ausgebildet und können durch Falten einen mäanderartigen Verlauf einnehmen. Gemäß einem Ausführungsbeispiel weist die Leiterplatte eines Lichtmoduls mehrere Einschnitte auf, die sich über zumindest 70% der Länge des Lichtmoduls erstrecken. Die Einschnitte durchtrennen die Leiterplatte nicht vollständig und erlauben ein ziehharmonikaartiges Auseinanderziehen des Lichtmoduls.

Die DE 203 19 650 Ul betrifft eine Reihe von Leuchtdioden zur flexiblen Gestaltung von leuchtenden Flächen, insbesondere für Rück-, Brems- oder Blinkleuchten in Fahrzeugen. Viele kleine LEDs werden in gleichförmigem Raster auf einer Leiterplatte angebracht, wobei die Leiterbahnführung so ausgelegt sein soll, dass beim Herausschneiden beliebiger Flächenteile die Funktion der übrigen LEDs erhalten bleibt. Der Verlauf der Leiterbahnen wird nicht beschrieben. Die Ansteuerung aller LEDs erfolgt über zwei Anschüsse.

Die EP 2 085 955 A1 zeigt ein Panel mit einer Leiterplatte, auf der LEDs in einem zweidimensionalen Array angeordnet sind. Die LEDs sind dabei jeweils über eine gemeinsame Leitung, die beispielsweise nicht als Leiterbahn sondern als gemeinsame Leiterschicht auf der Rückseite der Leiterplatte ausgebildet sein kann, und über eine zweite Leitung, die jede LED einzeln mit einer von mehreren Treiber verbindet, mit den Treibern verbunden.

Die DE-A-198 18 227 betrifft einen ortsveränderlichen Informationsträger, beispielsweise zur Verwendung als Sichtreklame an Gebäudefassaden etc., bestehend aus einer Flachleitermatrix mit offener Netzstruktur, die aus ummantelten Flachleitern gebildet wird, sowie Leuchtmitteln, die mit den Versorgungsleitern im Bereich der knotenberührenden Flachleiter elektrisch leitend verbunden sind, wobei die Flachleiter in den Knoten kraftübertragend miteinander verbunden sind.

In EP-A-1945015 weist eine Leitterplatte eine Vielzahl von Bohrungen auf, die in einer Matrix angeordnet sind. Eine Vielzahl von LED-einheiten ist in den Bohrungen angeordnet, wobei ein erster Leiterbahnstammabschnitt mindestens einen Leiterbahnstammbereich ausbildet.

Die im Stand der Technik bekannten Bauelemente und Systeme erweisen sich dahingehend als nachteilig, als dass sie eine eingeschränkte Flexibilität und Variabilität aufweisen. So ist beispielsweise die Grundform des Informationsträgers gemäß der DE-A-198 18 227 vorgegeben und kann nicht verändert werden. Auch die gemäß der DE 10 2006 033 894 A1 vorgeschlagene Lösung erlaubt nur eine begrenzte Variabilität der vorgeschlagenen Beleuchtungseinrichtung, nämlich durch Falten einer schmalen langen Leiterbahn oder durch ein ziehharmonikaartiges Vergrößern des Abstandes zweier paralleler Leiterbahnen mittels einer speziellen Verbindungsstruktur.

Dem gegenüber ist es eine Aufgabe der vorliegenden Erfindung, die Nachteile des Standes der Technik zu überwinden und insbesondere ein verbessertes Bauelement bereitzustellen. Weiterhin ist es eine Aufgabe der vorliegenden Erfindung, ein elektronisches Bauelement, insbesondere eine Leiterplatte, bereitzustellen, die eine vorteilhafte und variable Anordnung, mehrerer Abnehmer, insbesondere Leuchtmittel, erlaubt. Das Bauelement soll insbesondere eine flexible Verwendung und Adaption des Bauelements an sich sowie eine flexible Nutzung bzw. Ansteuerung der vorzugsweise verwendeten Leuchtmittel erlauben.

Diese Aufgabe(n) wird/werden gelöst durch den Gegenstand der vorliegenden Ansprüche sowie die nachfolgend diskutierten bevorzugten Aspekte der vorliegenden Erfindung.

Die vorliegende Erfindung betrifft ein elektronisches Bauelement, vorzugsweise eine Leiterplatte und besonders bevorzugt eine flexible Leiterplatte, die ein Trägermaterial und mehrere Leiterbahnen aufweist. Das Trägermaterial ist mit mehreren Befestigungsbereichen für Abnehmer, insbesondere für Leuchtmittel und besonders bevorzugt für LED versehen bzw. weist solche auf. Die Befestigungsbereiche bzw. Leuchtmittel sind über erste und zweite Leiterbahnen mit mindestens einem Anschlussbereich verbunden, wobei erste und zweite Leiterbahnen in dem mindestens einen Anschlussbereich zusammengeführt sind bzw. dort zusammenlaufen. Über einen derartigen Anschlussbereich sind beispielsweise die Leuchtmittel mit Strom versorgbar und/oder ansteuerbar. Die Leiterbahnen sind dabei derart angeordnet, dass sie eine Matrixschaltung bzw. -ansteuerung der Leuchtmittel erlauben.

Mehrere der ersten Leiterbahnen weisen jeweils mindestens einen ersten Leiterbahnastabschnitt und mindestens einen ersten Leiterbahnsstammabschnitt auf. Ebenso weisen die mehreren zweiten Leiterbahnen jeweils mindestens einen zweiten Leiterbahnastabschnitt und mindestens einen zweiten Leiterbahnstammabschnitt auf. Hierbei bilden erste und/oder zweite Leiterbahnstammabschnitte mindestens einen Leiterbahnstammbereich aus. Vorzugsweise verlaufen die den Leiterbahnstammbereich ausbildenden Abschnitte der ersten und zweiten Leiterbahnen in diesem im Wesentlichen parallel zueinander bzw. im Wesentlichen in die gleiche Richtung, wobei sie, insbesondere im Vergleich zum sonstigen Abstand der Leiterbahnen, eng nebeneinander angeordnet sind. Von entlang des Leiterbahnstammbereichs verlaufenden ersten und zweiten Leiterbahnen bzw. von einen Leiterstammbereich bildenden jeweiligen ersten und zweiten Leiterbahnstammabschnitten erstrecken sich erste und zweite Leiterbahnastabschnitte winklig. Das elektronische Bauelement bzw. die Leiterplatte weist also erste Leiterbahnen und zweite Leiterbahnen auf, die jeweils einen Leiterbahnastabschnitt und einen Leiterbahnstammabschnitt aufweisen, wobei sich diese vorzugsweise in einem Winkel zueinander erstrecken. Einige der ersten und/oder zweiten Leiterbahnstammabschnitte bilden einen Leiterbahnstammbereich aus, der nachfolgend noch weiter beschrieben wird. Die Leiterbahnastabschnitte verlaufen in einem Winkel zu dem jeweiligen Leiterbahnstammabschnitt bzw. zum Leiterbahnstammbereich. Der Winkel zwischen Stamm und Ast kann hierbei über einen scharfen Knick oder aber einen Radius erfolgen. Ast, Stamm und/oder Stammbereich verlaufen vorzugsweise im Wesentlichen geradlinig, können jedoch auch abweichende Verläufe, wie beispielsweise Radien oder Knicke aufweisen oder annehmen.

Weiterhin weist das Bauelement Leiterbahnäste auf, die durch wenigstens einen ersten und einen zweiten Leiterbahnastabschnitt gebildet werden und insbesondere durch die sich winklig zum jeweiligen Leiterbahnstammabschnitt bzw. zum Leiterbahnstammbereich verlaufenden Leiterbahnastabschnitte ausgebildet werden. Die einen Leiterbahnast bildenden Leiterbahn- bzw. Leiterbahnastabschnitte verlaufen entlang des Leiterbahnastes vorzugsweise im Wesentlichen parallel und/oder im Wesentlichen in die gleiche Richtung. Vorzugsweise sind sie, insbesondere im Vergleich zur übrigen Leiterbahnanordnung, dicht nebeneinander angeordnet.

Des Weiteren ist mindestens ein Befestigungsbereich entlang mindestens eines Leiterbahnastes angeordnet. Vorzugsweise sind mehrere Befestigungsbereiche entlang jeweils mehrerer Leiterbahnäste und/oder entlang der Leiterbahnstammabschnitts bzw. des Leiterbahnstammbereichs angeordnet. Die Befestigungsbereiche dienen der Verbindung zwischen einem Leuchtmittel und dem Trägermaterial, vorzugsweise der Leiterplatte bzw. den Leiterbahnen, wobei diese Verbindung direkt und/oder über Verbindungselemente, wie beispielsweise Halterungen erfolgen kann. Vorzugsweise weist das Bauelement an den Befestigungsbereichen Leuchtmittel, vorzugsweise LED auf.

Vorzugsweise sind die Befestigungsbereiche entlang eines Leiterbahnastes mit einem bzw. demselben den Leiterast bildenden ersten Leiterbahnastabschnitt mindestens einer ersten Leiterbahn verbunden. Diese Befestigungsbereiche sind auch mit einem zweiten Leiterbahnastabschnitt einer zweiten Leiterbahn des Leiterbahnastes verbunden, wobei diese Befestigungsbereiche jeweils mit einer anderen zweiten Leiterbahn verbunden sind. Beispielsweise weist ein Leiterbahnast drei oder mehr Befestigungsbereiche bzw. Leuchtmittel auf, die jeweils (in Reihe) mit der gleichen ersten Leiterbahn verbunden sind. Gleichzeitig sind diese drei Befestigungsbereiche mit jeweils einer anderen zweiten Leiterbahn verbunden. Dabei bilden die jeweiligen ersten und zweiten Leiterbahnastabschnitte, mit denen die Befestigungsbereiche verbunden sind, einen bzw. den Leiterbahnast, der sich winklig zum Leiterbahnstamm erstreckt.

Alternativ oder zusätzlich weist ein bzw. das elektronische Bauelement bzw. die Leiterplatte ein Trägermaterial mit mehreren Befestigungsbereichen für Leuchtmittel auf, die jeweils über erste und zweite Leiterbahnen mit mindestens einem Anschlussbereich verbunden sind. Die ersten und zweiten Leiterbahnen sind dabei derart angeordnet, dass mindestens ein Befestigungsbereich und diesen umgebendes Trägermaterial vom elektronischen Bauelement separierbar bzw. abtrennbar ausgeführt ist und zwar derart, dass mehrere verbleibende Befestigungsbereiche weiterhin über die ersten und zweiten Leiterbahnen mit dem mindestens einen Anschlussbereich verbunden sind. Die verbleibenden Befestigungsbereiche sind hierbei auch nach Abtrennen von den elektronischen Bauelementen mit dem diese umgebenen Trägermaterial im Sinne einer Matrixansteuerung ansteuerbar. Unter Matrixansteuerung wird hierbei insbesondere verstanden, dass unterschiedliche Abnehmer bzw. Leuchtmittel, die vorzugsweise im Wesentlichen in Reihen und Spalten angeordnet sind, durch individuelle Ansteuerung über jeweilige erste und zweite Leiterbahnen, mit denen sie verbunden sind, ansteuerbar sind. Die Befestigungsbereiche bzw. Leuchtmittel sind hierbei vorzugsweise flächig bzw. flächig verteilt angeordnet. Das Abtrennen von Befestigungsbereichen bzw. Leuchtmitteln kann hierbei, bei einer angenommenen spalten- und zeilenweisen Anordnung der Befestigungsbereiche, nicht nur in Eckbereichen erfolgen sondern auch entlang einzelner oder mehrerer mittig angeordneten Zeilen oder Spalten.

Alternativ und/oder zusätzlich sind die ersten und zweiten Leiterbahnen voneinander isoliert und vorzugsweise eng benachbart und ebenfalls bevorzugt im Wesentlichen parallel zueinander angeordnet, die mit mindestens zwei über mindestens eine erste Leiterbahn verbundenen, vorzugsweise direkt, benachbarten Befestigungsbereichen verbunden sind. Und zwar derart, dass auf dem Trägermaterial zumindest ein erster Bereich mit benachbarten ersten und zweiten Leiterbahnen entsteht, der so angeordnet ist, dass zwischen dem ersten Bereich und zumindest einer weiteren ersten und/oder zweiten Leiterbahn, die vorzugsweise einem ebenso ausgebildeten zweiten Bereich angehört, ein weiterer freier Trägermitteleinschnittbereich ausgebildet ist, der, vorzugsweise vom Rand des Trägermaterials her, leiterbahnfrei durchtrennbar ist. Die Bereiche entsprechen vorzugsweise Leiterbahnästen. Der Abstand der Leiterbahnen zweier Äste ist vorzugsweise größer, vorzugsweise wesentlich größer und besonders bevorzugt um ein Vielfaches größer, bspw. etwa 4x größer, bis zu 10x oder 20x größer, als zwischen Leiterbahnen eines Astes.

Das elektronische Bauelement bzw. das Trägermaterial weist somit mindestens einen Trennbereich auf. Dieser Trennbereich beinhaltet mindestens eine sich entlang dieses Bereichs erstreckende imaginäre Trennlinie entlang derer das Trägermaterial durchtrennt werden kann, wobei sich die Trennlinie und damit der Trennbereich zwischen benachbarten Leiterbahnästen erstreckt und wobei das Trägermaterial in dem Trennbereich bevorzugt keine Leiterbahnen aufweist bzw. wobei die imaginäre Trennlinie keine Leiterbahn schneidet oder durchtrennt. Beispielsweise wird auf (einen) leiterbahnfreie(n) Trennbereich(e) abgestellt, wobei es denkbar ist, dass auch im Trennbereich (eine) Leiterbahn(en) angeordnet ist bzw. sind, die jedoch ohne Beeinträchtigung der mit ihr verbundenen oder nicht verbundenen Leuchten durchtrennbar ist bzw. sind, falls (eine) solche Leiterbahn(en) mit (einer) Leuchte(n) verbunden ist bzw. sind. Ein Durchtrennen (einer) solcher Leiterbahn(en) hat demgemäß keine Auswirkung auf die Funktion der (Matrix-)Schaltung bzw. der (Matrix-)Ansteuerbarkeit der einzelnen Leuchte(n), die mit (einer) solchen Leiterbahn(en) gegebenenfalls in Verbindung steht bzw. stehen. Schneiden bzw. Durchtrennen in diesem Zusammenhang betrifft die vollständige, bspw. galvanische bzw. funktionale, Trennung eines Teils einer Leiterbahn von einem anderen. Ein Einschneiden in eine oder Spalten einer Leiterbahn, beispielsweise einer flächigen Leiterbahn, ist in diesem Zusammenhang nicht als Durchtrennen aufzufassen. Somit kann ein Einschnittbereich einer insbesondere flächigen, Leiterbahn einem Trennbereich zugeordnet sein bzw. letzterer ersteren aufweisen, insbesondere da keine funktonale oder galvanische Trennung vollzogen wird. Im Trennbereich ist das Trägermaterial bzw. das Bauelement somit entlang mehrerer Leuchtelemente bzw. Befestigungsbereiche durchtrennbar, ohne dass eine Leiterbahn durchtrennt und/oder die Funktion von Befestigungsbereichten und bspw. LED beeinträchtigt wird.

Vorzugsweise weist das elektronische Bauelement bzw. das Trägermaterial mindestens einen Ablängbereich auf, der entlang mindestens eines Leiterbahnastes und entlang mehrerer Leuchtmittel bzw. Befestigungsbereiche angeordnet ist und diese(n) zumindest teilweise umfasst. Der Ablängbereich ist seitlich mindestens durch einen Trennbereich, den Rand des Trägermaterials und/oder mindestens eine imaginäre Abtrennlinie, die mindestens eine erste und eine zweite Leiterbahn schneidet, begrenzt. Dabei ist der mindestens eine Ablängbereich derart separierbar, dass die verbleibenden, also nicht abgetrennten, ersten und zweiten Leiterbahnen des Leiterbahnastes weiterhin mit einem Anschlusselement verbunden sind.

Trennbereiche und/oder Ablängbereiche entlang der Trenn- bzw. Ablänglinie umfassen bzw. erstrecken sich entlang vorzugsweise mehreren Leuchtmitteln und vorzugsweise mindestens drei Leuchtmitteln.

Gemäß einer bevorzugten Ausführungsform kann das elektronische Bauelement entlang einer oder mehrerer imaginärer Trenn- und/oder Ablänglinien der Trenn- bzw. Ablängbereiche mindestens einen Solltrennbereich aufweisen. Dieser kann durch eine verringerte Dicke des Trägermaterials, durch eine oder mehrere Perforationen und/oder mindestens eine Aussparung ausgebildet sein.

Erfindungsgemäß wird also eine Leiterbahnplatte mit einer Leiterbahnanordnung bereitgestellt, die einen Leiterbahnstammbereich von im Wesentlichen parallel bzw. sich im Wesentlichen in die gleiche Richtung verlaufenden ersten und zweiten Leiterbahnstammabschnitten erster und zweiter Leiterbahnen aufweist. Von diesem Leiterbahnstammbereich erstrecken sich vorzugsweise mehrere Leiterbahnäste, ebenfalls umfassend erste und zweite Leiterbahnastabschnitte, die im Wesentlichen parallel oder im Wesentlichen in die gleiche Richtung verlaufen. Die Leiterbahnäste bzw. die sie bildenden Leiterbahnastabschnitte erstrecken sich winklig zum Leiterbahnstammbereich bzw. den diesen bildenden Leiterbahnstammabschnitt. Mehrere Leuchtmittel, vorzugsweise alle Leuchtmittel, eines Leiterbahnastes sind mit derselben mindestens einen ersten Leiterbahn verbunden. Mehrere Leuchtmittel, vorzugsweise alle Leuchtmittel, dieses Leiterbahnastes sind dabei mit jeweils einer anderen zweiten Leiterbahn bzw. deren Leiterbahnastabschnitt verbunden. Ein Leiterbahnastabschnitt wird somit vorzugsweise gebildet aus mindestens einem ersten Leiterbahnastabschnitt sowie mehreren zweiten Leiterbahnastabschnitten, wobei die Zahl der mehreren zweiten Leiterbahnastabschnitte vorzugsweise der Zahl der auf dem jeweiligen Ast vorgesehenen bzw. angeordneten Leuchtmittel entspricht.

Die ersten und zweiten Leiterbahnen sind in ihren einander entsprechenden Abschnitten, beispielsweise den Astabschnitten und im Leiterbahnstammbereich, voneinander isoliert und unmittelbar benachbart angeordnet und vorzugsweise erstrecken sie sich im Wesentlichen parallel und/oder verlaufen im Wesentlichen in die gleiche Richtung. Gemäß einer bevorzugten Ausführungsform verlaufen die Leiterbahnen eines Astes und/oder des Stammbereichs, beispielsweise abhängig vom verwendeten Herstellungsverfahren und/oder der Anzahl und Leistung der verwendeten Leuchtmittel, in einem Abstand von etwa 100 bis 500 µm. Der Abstand der Leiterbahnen zweier Äste liegt vorzugsweise im Bereich von etwa mehreren mm, vorzugsweise etwa 2 bis 14 mm. Insbesondere sollte der Abstand zwischen zwei Ästen derart gewählt sein, dass ein Trennen entlang einer zwischen den Ästen verlaufenden Trennlinie möglich ist. Weiterhin können die Art der eingesetzten Leuchtmittel sowie das auszubildende Raster, also die flächige Anordnung der Leuchtmittel, sowie die für die Leuchtmittel erforderliche Stromstärke berücksichtigt werden.

Das Trägermaterial des erfindungsgemäßen Bauelements ist vorzugsweise als flexible Folie oder aber als starre, vorzugsweise biegbare und/oder knickbare Platte ausgebildet. Das erfindungsgemäße Bauelement ist vorzugsweise als Leiterbahnanordnung, vorzugsweise als flexible Leiterbahnanordnung zur Verwendung als mit mehreren Leuchtmitteln, vorzugsweise LED, versehene Displayanordnung ausgebildet. Herstellung und Aufbau des Bauelements, insbesondere des Trägermaterials, der Leiterbahnen, der Befestigungsbereiche und der Leuchtmittel, erfolgt dabei vorzugsweise gemäß den herkömmlich bekannten Arten, wobei der Leiterbahnverlauf erfindungsgemäß realisiert ist.

Vorzugsweise mündet der mindestens eine Leiterbahnstammbereich in mindestens einen Anschlussbereich. In Bezug auf die Geometrie des elektronischen Bauelements bzw. des Trägermaterials ist der Stammbereiche und/oder Anschlussbereich beispielsweise in der Mitte, im Randbereich oder im Eckbereich des Trägermaterials angeordnet. Damit lässt sich ein individueller Einsatz und insbesondere eine individuelle Anordnung des Bauelements im Raum und/oder in Bezug auf andere Bauelemente erreichen, wobei Ansteuerungs- bzw. Verbindungswege etc. vorteilhaft gewählt werden können. Vorzugsweise ist das Bauelement modulartig mit mehreren erfindungsgemäßen Bauelementen verbindbar.

Das Bauelement weist vorzugsweise in jedem Befestigungsbereich mindestens ein, vorzugsweise drei oder mehr, Leuchtmittel, insbesondere LED, auf. Hierbei kann pro Befestigungsbereich eine rotes Licht emittierende LED, eine grünes Licht emittierende LED und/oder eine blaues Licht emittierende LED etc. oder eine integrierte LED, beispielsweise eine RGB-LED vorgesehen sein.

Vorzugsweise ist das elektronische Bauelement mit einer Steuerung versehen, die im Anschlussbereich angeordnet oder mit diesem verbunden ist, und die mit mindestens einer ersten und mit mindestens einer zweiten Leiterbahn, vorzugsweise mit allen Leiterbahnen, verbunden ist. Ein Anschlussbereich kann beispielsweise mindestens ein Steuerbauelement, mindestens ein (Treiber-)Chip und/oder mindestens ein Anschlusselement wie einen Stecker aufweisen. Solche Chips sind beispielsweise Transistoren wie MOSFETs und dienen insbesondere als Transistorschaltstufen. Die ersten und zweiten Leiterbahnen des erfindungsgemäßen elektronischen Bauelements, wie oben beschrieben, sind vorzugsweise als Anode bzw. Kathode einer Matrixschaltung ausgebildet. Die Steuerung ist vorzugsweise eine zur Matrixschaltung ausgebildete Steuerung. Des Weiteren sind die Leuchtmittel auf dem Trägermaterial im Wesentlichen in Reihen und Spalten angeordnet, sie können jedoch auch eine chaotische Anordnung annehmen. In jedem Fall sind die Leuchtmittel bzw. die Leiterbahnen, unabhängig ihrer tatsächlichen räumlichen Positionierung, im Sinne einer Matrixschaltung zeilen- und spaltenweise ansteuerbar.

Vorzugsweise weisen die Befestigungsbereiche gleiche bzw. im Wesentlichen gleiche Abstände zueinander auf, die vorzugsweise im Bereich von 3 mm bis 4 cm liegen.

Gemäß einer bevorzugten Ausführungsform weist das Bauelement zwei Leiterbahnstammbereiche und/oder Anschlussbereiche auf, die vorzugsweise auf gegenüberliegenden Seiten des Trägermaterials vorgesehen sind. Vorzugsweise sind dabei die ersten und zweiten Leiterbahnen, die auf dem Bauelement angeordnet sind jeweils mit beiden Leiterbahnstammbereichen und/oder Anschlussbereichen verbunden. Eine derartige Anordnung mit zwei Anschlussbereichen erlaubt das vollständige Durchtrennen des Bauelements zwischen den gegenüberliegenden Leiterbahnstammbereichen, ohne die Funktionalität und Ansteuerbarkeit der Leuchtmittel auf beiden verbleibenden bzw. getrennten Bauelementteilen zu beeinträchtigen.

Die erfindungsgemäßen Vorteile können weiter verstärkt werden, indem gemäß einer bevorzugten Ausführungsform im Sinne der obigen Erläuterungen ein Leiterbahnast einen oder mehrere Leiterbahnzweige aufweist bzw. sich in solche unterteilt. Weiter erhöht werden kann die vorteilhafte Funktionalität der vorliegenden Erfindung wenn ein Leiterbahnzweig einen oder mehrere Leiterbahnunterzweige aufweist bzw. sich in solche unterteilt. Wie für den Fachmann ohne weiteres ersichtlich, kann eine derartige Strukturierung weiter fortgesetzt werden. Leiterbahnzweige bzw. Leiterbahnunterzweige etc. sind dabei gemäß der obigen Diskussion der Leiterbahnäste durch erste und zweite Leiterbahnzweig- bzw. Leiterbahnunterzweigabschnitte gebildet.

Mindestens zwei der ersten und/oder zweiten Leiterbahnen sind vorzugsweise mindestens abschnittsweise in verschiedenen Ebenen angeordnet. Die Ebenen verlaufen dabei insbesondere zumindest abschnittsweise parallel zum Substrat bzw. der Ebene, in der sich das Substrat erstreckt. Mindestens zwei der ersten und/oder zweiten Leiterbahnen können sich ferner mindestens abschnittsweise überlappen, bevorzugt in Abschnitten, die in verschiedenen Ebenen angeordnet sind. Auch können mehrere der ersten und/oder zweiten Leiterbahnen mindestens abschnittsweise mehrlagig oder geschichtet angeordnet sein, wobei die einzelnen Lagen oder Schichten bevorzugt voneinander isoliert sind. Die mindestens abschnittsweise in verschiedenen Ebenen verlaufenden und/oder mehrlagig oder geschichtet angeordneten ersten und/oder zweiten Leiterbahnen können ferner abschnittsweise, bevorzugt im Stammbereich, in einer gemeinsamen Ebene verlaufen. Dabei sind die ersten und zweiten Leiterbahnen bevorzugt im Stammbereich parallel zueinander in einer Ebene angeordnet. Die ersten und/oder zweiten Leiterbahnen können also zumindest abschnittsweise eine beliebige Kombination von in einer Ebene, bevorzugt parallel zueinander, angeordneten Leiterbahnen und/oder in verschiedenen Ebenen, bevorzugt parallel zueinander, angeordneten Leiterbahnen bzw. Leiterbahnabschnitten aufweisen. Mit anderen Worten ist eine Kombination aus geschichteten und in einer Ebene verlaufenden Leiterbahnen möglich.

Mindestens eine der ersten und/oder zweiten Leiterbahnen ist vorzugsweise mindestens abschnittsweise flächig ausgebildet. Mindestens eine der ersten und/oder zweiten Leiterbahnen weist vorzugsweise mindestens abschnittsweise eine im Vergleich zu anderen Bereichen der, vorzugsweise derselben, ersten und/oder zweiten Leiterbahnen eine gesteigerte Leiterbahnbreite auf.

Der mindestens einen Leiterbahnast, der mindestens eine Leiterbahnzweig, und/oder der mindestens ein Leiterbahnunterzweig weisen beispielsweise eine Breite zwischen 2 mm und 100 mm, bevorzugt zwischen 2 mm und 60 mm, und besonders bevorzugt zwischen 3 mm und 40 mm auf. Auch kann mindestens eine der ersten und/oder zweiten Leiterbahnen redundant ausgebildet sein. Dabei verfügt eine redundante Leiterbahn über die gleiche Funktionalität wie die Original-Leiterbahn und erlaubt insbesondere die gleiche Ansteuerbarkeit eines Befestigungsbereiches, bspw. Leuchtmittels. Eine in dieser Anmeldung als flächig bezeichnete Leiterbahn hat vorzugsweise eine Breite von größer als 3mm, weiter bevorzugt von größer als 20mm, weiter bevorzugt von größer als 40mm und noch weiter bevorzugt von größer als 60mm.

Des Weiteren betrifft die vorliegende Erfindung vorzugsweise ein Verfahren zur Herstellung eines elektronischen Bauelements mit den oben diskutierten Merkmalen sowie ein Verfahren zur Individualisierung eines erfindungsgemäßen Bauelements durch Durchtrennen des Trägermaterials und bzw. zur Veränderung der räumlichen Position von Leuchtmitteln zueinander und/oder durch Abtrennen von Leuchtmitteln zusammen mit dem sie umgebenden Trägermaterial.

Das erfindungsgemäße Bauelement ist vorzugsweise ausgebildet als Display zur Informationsvermittlung und/oder als Effektbeleuchtung oder Dekorationsmittel. Das Bauelement ist insbesondere zur Verwendung in dreidimensionaler Freiform vorgesehen. Gemäß einer alternativen Ausführungsform kann das erfindungsgemäße Bauelement zusätzlich oder anstelle von Leuchtmitteln mit anderen Komponenten, beispielsweise Sensoren, versehen sein bzw. mit diesen verwendet werden. Das Bauelement ist dann als Sensoreinrichtung ausgebildet.

Das erfindungsgemäße Bauelement kann somit besonders vorteilhaft kostengünstig nach herkömmlichen und bewährten Prinzipien hergestellt und aufgebaut sein, wobei dennoch durch die besondere Struktur der Leiterbahnanordnung eine vorteilhafte Anwendung und ein vorteilhafter Einsatz ermöglicht wird. Insbesondere ist ein vorteilhafter und individualisierter Einsatz des Bauelements bzw. der Leiterplatte möglich, wobei diese hinsichtlich ihrer flächigen Geometrie als auch ihrer dreidimensionalen Ausbildung angepasst, eingestellt und verwendet werden kann. Es wird gewährleistet, dass durch das Einschneiden des Trägermaterials entlang mehrerer Leuchtmittel vorteilhafte geometrische dreidimensionale Erstreckungen der Leiterplatte realisiert werden können. Gleichzeitig oder alternativ lassen sich individuelle Grundformen der Leiterplatte durch Ablängen bzw. Abtrennen verschiedener Bereiche inklusive Leuchtmitteln erreichen. Bei all dem wird die Funktionalität der verbleibenden Leuchtmittel und damit deren breites Einsatzspektrum nicht beeinträchtigt. Insbesondere lässt sich das erfindungsgemäßen Bauelement einfach und kostengünstig in den bevorzugten Einsatzbereichen, insbesondere in dreidimensionaler Freiform, verwenden

Die vorliegende Erfindung stellt somit eine besonders vorteilhafte Ausgestaltung eines elektronischen Bauelements bzw. einer Leiterplatte mit darauf angeordneten ersten und zweiten Leiterbahnen zur Ansteuerung von Leuchtmitteln bereit, wobei das Bauelement individuell einsetzbar und adaptierbar ist und zwar insbesondere durch die Möglichkeit, verschiedene Einschnitte entlang mehrerer Leuchtelemente vorzusehen und/oder aber einzelne oder mehrere Leuchtmittel abzutrennen. Dabei bleibt die vorteilhafte, vorzugsweise matrixartige, Ansteuerbarkeit der verbleibenden Leuchtmittel erhalten.

Hierbei lassen sich vorteilhafterweise einfach und günstige einheitlich fertig produzierte, einsatzbereite Leiterplatten bzw. Bauelemente mit einer einheitlichen Grundform nachträglich, also nach Herstellung und während bzw. vor Einsatz derselben, individualisiert zuschneiden und/oder verformen. Somit kann dem jeweiligen Einsatzgebiet bzw. Einsatzort und Einsatzzweck individuell Rechnung getragen werden. Es können sogar individuelle dreidimensionale Formen durch die Leiterplatte angenommen werden.

Dabei bleibt die individuelle Ansteuerbarkeit und Nutzbarkeit der Leiterplatte, beispielsweise als Display für wechselnde Informationsdarstellung bzw. Wiedergabe, vorzugsweise im Rahmen einer Matrixansteuerung, erhalten.

Die vorliegende Erfindung betrifft gemäß alternativen und/oder zusätzlichen bevorzugten Merkmalen die nachfolgenden Aspekte:
1. Elektronisches Bauelement (1), aufweisend
   ein Trägermaterial (2), dass mehrere Befestigungsbereiche (3), insbesondere für Leuchtmittel, aufweist, die jeweils über erste Leiterbahnen (4) und zweite Leiterbahnen (5) mit mindestens einem Anschlussbereich (8) verbunden oder verbindbar sind,
   wobei die ersten und zweiten Leiterbahnen (4, 5) derart angeordnet sind, dass mindestens ein Befestigungsbereich (3) und diesen umgebendes Trägermaterial (2) vom elektronischen Bauelement (1) separierbar ausgeführt ist, derart, dass mehrere verbleibende Befestigungsbereiche (3) weiterhin über die ersten und zweiten Leiterbahnen (4, 5) in einer zur Matrixansteuerung geeigneten Weise mit dem mindestens einen Anschlussbereich (8) verbunden sind, und/oder
   wobei zumindest die ersten und zweiten Leiterbahnen (4, 5) voneinander isoliert und, vorzugsweise eng benachbart und vorzugsweise im Wesentlichen parallel zueinander angeordnet sind, die mit mindestens zwei über mindestens eine erste Leiterbahn (4), vorzugsweise direkt, benachbarten Befestigungsbereichen (3) verbunden sind, so dass auf dem Trägermaterial (2) zumindest ein erster Bereich mit benachbarten ersten und zweiten Leiterbahnen (4, 5) entsteht, der derart auf dem Trägermaterial (2) angeordnet ist, dass zwischen dem ersten Bereich und zumindest einer weiteren ersten und/oder zweiten Leiterbahn (4, 5), die vorzugsweise einem zweiten Bereich angehört, ein leiterbahnfreier und vom Rand des Trägermaterial (2) her leiterbahnfrei durchtrennbarer Trägermaterialeinschnittbereich ausgebildet ist.
2. Elektronisches Bauelement (1), nach Aspekt 1, wobei die ersten und zweiten Leiterbahnen (4, 5) des ersten Bereichs ferner so mit dem mindestens einen Anschlussbereich (8) verbunden oder verbindbar sind, dass zumindest ein randnaher Befestigungsbereich (3) durch Durchtrennen des umgebenden Trägermaterials (2) vom Trägermaterial (2) derart separierbar ist, dass zumindest ein auf dem Bauelement (1) bzw. dem Trägermaterial (2) verbleibender Befestigungsbereich (3) weiterhin über die ersten und zweiten Leiterbahnen (4, 5) mit dem zumindest einem Anschlussbereich (8) verbunden oder verbindbar ist.
3. Elektronisches Bauelement (1), insbesondere nach Aspekt 1 oder 2, aufweisend ein Trägermaterial (2) und mehrere Leiterbahnen,
   wobei das Trägermaterial (2) mehrere Befestigungsbereiche (3), insbesondere für Leuchtmittel, aufweist, die jeweils über erste Leiterbahnen (4) und zweite Leiterbahnen (5) mit mindestens einem Anschlussbereich (8) verbunden oder verbindbar sind,
   wobei erste und/oder zweite Leiterbahnen (4, 5) in dem mindestens einen Anschlussbereich zusammengeführt sind,
   wobei mehrere der ersten Leiterbahnen (4) jeweils mindestens einen ersten Leiterbahnastabschnitt (4a) und mindestens einen ersten Leiterbahnstammabschnitt (4b) aufweisen, und/oder wobei mehrere der zweiten Leiterbahnen (5) jeweils mindestens einen zweiten Leiterbahnastabschnitt (5a) und mindestens einen zweiten Leiterbahnstammabschnitt (5b) aufweisen,
   wobei erste und/oder zweite Leiterbahnstammabschnitte (4b, 5b) mindestens einen Leiterbahnstammbereich (6) ausbilden,
   wobei sich erste und/oder zweite Leiterbahnastabschnitte (4a, 5a) von entlang des Leiterbahnstammbereichs (6) verlaufenden ersten und zweiten Leiterbahnen (4, 5) von diesem Leiterbahnstammbereich (6) und/oder von den jeweiligen ersten und zweiten Leiterbahnstammabschnitten winkelig erstrecken und Leiterbahnäste (7) bilden,
   wobei ein Leiterbahnast (7) durch wenigstens einen ersten und/oder einen zweiten Leiterbahnastabschnitt (4a, 5a) gebildet ist, und
   wobei mindestens ein Befestigungsbereich (3) entlang mindestens eines Leiterbahnastes (7) angeordnet ist.
4. Elektronisches Bauelement (1) nach Aspekt 3, wobei Befestigungsbereiche (3) entlang eines Leiterbahnastes (7) mit einem den Leiterbahnast (7) bildenden ersten Leiterbahnastabschnitt (4a) mindestens einer ersten Leiterbahn (4) verbunden sind, und wobei diese Befestigungsbereiche (3) jeweils mit einem den Leiterbahnast (7) bildenden zweiten Leiterbahnastabschnitt (5a) einer zweiten Leiterbahn (5) des Leiterbahnastes (7) verbunden sind.
5. Elektronisches Bauelement (1) nach einem der vorangehenden Aspekte,
   wobei alle Befestigungsbereiche (3) oder mindestens zwei Befestigungsbereiche (3) entlang eines Leiterbahnastes (7) mit einem den Leiterbahnast (7) bildenden ersten Leiterbahnastabschnitt (4a) mindestens einer ersten Leiterbahn (4) verbunden sind.
6. Elektronisches Bauelement (1) nach einem der vorangehenden Aspekte,
   wobei mindestens zwei Befestigungsbereiche (3), vorzugsweise jeder Befestigungsbereich (3) entlang eines Leiterbahnastes (7) mit einer anderen zweiten Leiterbahn (5) verbunden sind.
7. Elektronisches Bauelement (1) insbesondere nach einem der vorangehenden Aspekte, mit einem Trägermaterial (2), dass mehrere Befestigungsbereiche (3), insbesondere für Leuchtmittel, aufweist, die jeweils über erste Leiterbahnen (4) und zweite Leiterbahnen (5) mit mindestens einem Anschlussbereich (8) verbunden sind,
   wobei erste und zweite Leiterbahnen (4, 5) mittels vorzugsweise im Wesentlichen eng beanstandet und/oder im Wesentlichen parallel zueinander verlaufenden ersten und zweiten Leiterbahnabschnitten bzw. Leiterbahnastabschnitten (4a, 5a) mehrere Leiterbahnäste (7) ausbilden,
   wobei mehrere Befestigungsbereiche (3) eines Leiterbahnastes (7), vorzugsweise alle Befestigungsbereiche (3), mit einem ersten Leiterbahnastabschnitt (4a) mindestens einer ersten Leiterbahn (4) verbunden sind, und wobei die mehreren Befestigungsbereiche (3), vorzugsweise jeder Befestigungsbereich (3), mit jeweils einer anderen zweiten Leiterbahn (5) verbunden sind
   wobei mehrere zweite Leiterbahnen (5) jeweils mindestens zwei Leiterbahnastabschnitte (5a) der mehreren Leiterbahnäste (7) ausbilden und/oder wobei mehrere zweite Leiterbahnen (5) jeweils mit mindestens einem Befestigungsbereich (3) verschiedener Leiterbahnastabschnitte (5a) der mehreren Leiterbahnäste (7) verbunden sind.
8. Elektronisches Bauelement (1) nach einem der einem der vorangehenden Aspekte, wobei mindestens ein Leiterbahnast (7) mindestens einen Leiterbahnzweig (9) aufweist und/oder sich in mindestens zwei Leiterbahnzweige (9) aufteilt,
   wobei entlang der Leiterbahnzweige (9) Befestigungsbereiche (3), bevorzugt jeweils mindestens ein, besonders bevorzugt mindestens zwei oder drei Befestigungsbereich(e) (3) pro Leiterbahnzweig (9), angeordnet sind,
   wobei der Leiterbahnast (7) erste und zweite Leiterbahnen (4, 5) bzw. erste und zweite Leiterbahnastabschnitte (4a, 5a) umfasst, die ferner erste und zweite Leiterbahnzweigabschnitte (4c, 5c) aufweisen, und
   wobei ein Leiterbahnzweig (9) durch wenigstens einen ersten und einen zweiten Leiterbahnzweigabschnitt (4c, 5c) gebildet ist.
9. Elektronisches Bauelement (1) nach Aspekt 8, wobei Befestigungsbereiche (3) entlang eines Leiterbahnzweiges (9) mit einem den Leiterbahnzweig (9) bildenden ersten Leiterbahnzweigabschnitt (4c) mindestens einer ersten Leiterbahn (4) verbunden sind, und wobei diese Befestigungsbereiche (3) jeweils mit einem zweiten Leiterbahnzweigabschnitt (5c) einer zweiten Leiterbahn (5) des Leiterbahnzweiges (9) verbunden sind.
10. Elektronisches Bauelement (1) nach Aspekt 8 oder 9, wobei mindestens zwei Befestigungsbereiche (3), vorzugsweise alle Befestigungsbereiche (3), entlang eines Leiterbahnzweiges (9) mit einem den Leiterbahnzweig (9) bildenden ersten Leiterbahnzweigabschnitt (4c) mindestens einer ersten Leiterbahn (4) verbunden sind.
11. Elektronisches Bauelement (1) nach Aspekt 8, 9 oder 10, wobei mindestens zwei Befestigungsbereiche (3), vorzugsweise jeder Befestigungsbereich (3), eines Leiterbahnzweiges (9) mit einer anderen zweiten Leiterbahn (5) verbunden sind/ist.
12. Elektronisches Bauelement (1) nach einem der vorangehenden Aspekte, wobei Leiterbahnzweige (9) entsprechend ausgebildete Leiterbahnunterzweige (9i) aufweisen.
13. Elektronisches Bauelement (1) nach einem der Aspekte 8 bis 11, wobei mindestens ein Leiterbahnzweig (9) mindestens einen Leiterbahnunterzweig (9i) aufweist und/oder sich in mindestens zwei Leiterbahnunterzweige (9i) aufteilt,
   wobei entlang der Leiterbahnunterzweige (9i) Befestigungsbereiche (3), bevorzugt jeweils mindestens ein Befestigungsbereich (3) pro Leiterbahnunterzweig (9i), angeordnet sind,
   wobei der Leiterbahnunterzweig (9i) erste und zweite Leiterbahnen (4, 5) bzw. erste und zweite Leiterbahnzweigabschnitte (4c, 5c) umfasst, die ferner erste und zweite Leiterbahnunterzweigabschnitte (4i, 5i) aufweisen, und
   wobei ein Leiterbahnunterzweig (9i) durch wenigstens einen ersten und einen zweiten Leiterbahnunterzweigabschnitt (4i, 5i) gebildet ist.
14. Elektronisches Bauelement (1) nach Aspekt 13, wobei Befestigungsbereiche (3) entlang eines Leiterbahnunterzweiges (9i) mit einem den Leiterbahnunterzweig (9i) bildenden ersten Leiterbahnunterzweigabschnitt (4i) mindestens einer ersten Leiterbahn (4) verbunden sind, und
   wobei diese Befestigungsbereiche (3) jeweils mit einem zweiten Leiterbahnunterzweigabschnitt (5i) einer zweiten Leiterbahn (5) des Leiterbahnunterzweiges (9i) verbunden sind.
15. Elektronisches Bauelement (1) nach Aspekt 13 oder 14, wobei mindestens zwei Befestigungsbereiche (3), vorzugsweise alle Befestigungsbereiche (3), entlang eines Leiterbahnzweiges (9) mit einem den Leiterbahnunterzweig (9i) bildenden ersten Leiterbahnunterzweigabschnitt (4i) mindestens einer ersten Leiterbahn (4) verbunden sind.
16. Elektronisches Bauelement (1) nach Aspekt 13, 14 oder 15, wobei mindestens zwei Befestigungsbereiche (3), vorzugsweise alle Befestigungsbereiche (3), eines Leiterbahnunterzweiges (9i) mit einer anderen zweiten Leiterbahn (5) verbunden sind.
17. Elektronisches Bauelement (1) nach einem der vorangehenden Aspekte, wobei erste und zweite Leiterbahnen (4, 5) in ihren einander entsprechenden Abschnitten voneinander isoliert und unmittelbar benachbart angeordnet sind.
18A. Elektronisches Bauelement (1) nach einem der vorangehenden Aspekte,
   wobei erste und zweite Leiterbahnen (4, 5), zumindest in einem ihrer einander entsprechenden Abschnitte, im Wesentlichen parallel zueinander verlaufen.
18B. Elektronisches Bauelement (1) nach einem der vorangehenden Aspekte, wobei mindestens zwei der ersten und/oder zweiten Leiterbahnen (4, 5) mindestens abschnittsweise in verschiedenen Ebenen angeordnet sind.
18B1. Elektronisches Bauelement (1) nach Aspekt 18B, wobei sich mindestens zwei der ersten und/oder zweiten Leiterbahnen (4, 5) mindestens abschnittsweise überlappen, bevorzugt in Abschnitten, die in verschiedenen Ebenen angeordnet sind.
18B2. Elektronisches Bauelement (1) nach einem der vorangehenden Aspekte, wobei mindestens zwei der ersten und/oder zweiten Leiterbahnen (4, 5) mindestens abschnittsweise mehrlagig oder geschichtet angeordnet sind, wobei die einzelnen Lagen oder Schichten voneinander isoliert sind.
18B3. Elektronisches Bauelement (1) nach Aspekt 18B1 oder 18B2, wobei die mindestens abschnittsweise in verschiedenen Ebenen verlaufenden und/oder mehrlagig oder geschichtet aufgebauten ersten und/oder zweiten Leiterbahnen (4, 5) abschnittsweise, in einer gemeinsamen Ebene verlaufen.
18C. Elektronisches Bauelement (1) nach einem der vorangehenden Aspekte, wobei mindestens eine der ersten und/oder zweiten Leiterbahnen (4, 5) mindestens abschnittsweise flächig ausgebildet ist.
18C1. Elektronisches Bauelement (1) nach einem der vorangehenden Aspekte, wobei mindestens eine der ersten und zweiten Leiterbahnen (4, 5) mindestens abschnittsweise eine im Vergleich zu anderen Bereichen der ersten und/oder zweiten Leiterbahnen (4, 5) eine gesteigerte Leiterbahnbreite aufweist.
18C2. Elektronisches Bauelement (1) nach einem der vorangehenden Aspekte, wobei der mindestens einen Leiterbahnast (7), der mindestens eine Leiterbahnzweig (9), und/oder der mindestens ein Leiterbahnunterzweig (9i) eine Breite zwischen 2 mm und 100 mm, bevorzugt zwischen 2 mm und 60 mm, und besonders bevorzugt zwischen 3 mm und .40 mm aufweist.
18D. Elektronisches Bauelement (1) nach einem der vorangehenden Aspekte, wobei mindestens eine der ersten und/oder zweiten Leiterbahnen (4, 5) redundant ausgebildet ist.
19. Elektronisches Bauelement (1) nach einem der vorangehenden Aspekte,
   wobei die den mindestens einen Leiterbahnstammbereich (6) ausbildenden ersten und zweiten Leiterbahnstammabschnitte (4b, 5b) der ersten und zweiten Leiterbahnen (4, 5) im Wesentlichen parallel zueinander verlaufen.
20. Elektronisches Bauelement (1) nach einem der vorangehenden Aspekte,
   wobei das Trägermaterial (2) als eine flexible Folie oder als starre, vorzugsweise biegbare und/oder knickbare, Platte ausgebildet ist.
21. Elektronisches Bauelement (1) nach einem der vorangehenden Aspekte,
   wobei das Trägermaterial (2) flach und/oder im Wesentlichen flächig ausgebildet ist, und wobei das Trägermaterial (2) die Grundform eines Vielecks, insbesondere eines Rechtecks, Dreiecks oder Quadrates, eines Kreises und/oder eines Ovals aufweist.
22. Elektronisches Bauelement (1) nach einem der vorangehenden Aspekte,
   wobei das elektronische Bauelement (1) mindestens einen Leiterbahnstammbereich (6), mindestens ein Chip, und/oder einen Anschlussbereich (8) in der Mitte, im Randbereich, und/oder im Eckbereich des Trägermaterials (2) aufweist.
23. Elektronisches Bauelement (1) nach einem der vorangehenden Aspekte,
   wobei das Trägermaterial (2) die Grundform eines Vielecks aufweist,
   wobei ein Anschlussbereich (8) im Eckbereich des Trägermaterials (2) angeordnet ist, und wobei sich ein Leiterbahnstammbereich (6) entlang einer Kante des Trägermaterials (2) erstreckt.
24. Elektronisches Bauelement (1) nach einem der vorangehenden Aspekte,
   wobei das Trägermaterial (2) mindestens einen Trennbereich (10) mit mindestens einer sich entlang dieses Bereichs erstreckenden Trennlinie (13) aufweist, der zwischen benachbarten Leiterbahnästen (7) und/oder Leiterbahnzweigen (9) und/oder Leiterbahnunterzweigen (9i) angeordnet ist, und
   wobei das Trägermaterial (2) in dem mindestens einem Trennbereich (10) keine Leiterbahn aufweist.
25. Elektronisches Bauelement (1) nach einem der vorangegangenen Aspekte, wobei das Trägermaterial (2) mindestens einen Ablängbereich (11), aufweist, der entlang mindestens eines Leiterbahnastes (7) und/oder Leiterbahnzweiges (9) und/oder Leiterbahnunterzweiges (9i) angeordnet ist und diesen zumindest teilweise umfasst,
   wobei der Ablängbereich (11) seitlich durch mindestens einen Trennbereich (10), den Rand des Trägermaterials (2) und/oder eine Ablänglinie (14), die mindestens eine erste und eine zweite Leiterbahn (4, 5) schneidet, begrenzt ist, und
   wobei der mindestens eine Ablängbereich (11) derart separierbar ist, dass die ersten und zweiten Leiterbahnen (4, 5) der Leiterbahnäste (7) und/oder Leiterbahnzweige (9) und/oder Leiterbahnunterzweige (9i) des elektronischen Bauelements (1) weiterhin mit einem Anschlusselement (8) verbunden sind.
26. Elektronisches Bauelement (1) nach Aspekt 24 oder 25, wobei die Trennbereiche (10) und/oder die Ablängbereiche (11) entlang der Trennlinie und/oder Ablänglinie zumindest teilweise mindestens einen Solltrennbereich mit einer im Vergleich zur Trägermaterialdicke geringeren Dicke und/oder mindestens eine Perforation und/oder mindestens eine Aussparung aufweisen.
27. Elektronisches Bauelement (1) nach einem der vorangehenden Aspekte, wobei in einem Befestigungsbereich (3) mindestens ein, bevorzugt drei, Leuchtmittel, vorzugsweise LED, vorgesehen sind.
28. Elektronisches Bauelement (1) nach einem der vorangehenden Aspekte, wobei jedes Leuchtmittel eines Befestigungsbereiches (3) an mit dem jeweiligen Befestigungsbereich (3) in Verbindung stehende(n) zweite(n) Leiterbahn(en) (5) angeschlossen ist, und
   wobei gleichzeitig jedes Leuchtmittel eines Befestigungsbereiches (3) jeweils an genau eine erste Leiterbahn (4) angeschlossen ist, so dass jede erste mit dem Befestigungsbereich (3) verbundene Leiterbahn (4) genau einem Leuchtmittel des Befestigungsbereichs (3) zugeordnet ist.
29. Elektronisches Bauelement (1) nach einem der vorangehenden Aspekte, wobei als Leuchmittel LEDs, bevorzugt pro Befestigungsbereich eine rotes Licht emittierende LED, eine grünes Licht emittierende LED und eine blaues Licht emittierende LED, oder eine integrierte RGB-LED vorgesehen sind.
30. Elektronisches Bauelement (1) nach einem der vorangehenden Aspekte, wobei das Trägermaterial (2) aus Aluminium oder aus einem Kunststoff, insbesondere aus einem Polyamid, hergestellt ist bzw. dieses aufweist.
31. Elektronisches Bauelement (1) nach einem der vorangehenden Aspekte, wobei im Anschlussbereich (8) mindestens eine Steuerung (12) und/oder mindestens ein Chip vorgesehen ist, die mit mindestens einer ersten Leiterbahn (4) und mit mindestens einer zweiten Leiterbahn (5) verbunden ist, oder
   wobei im Anschlussbereich (8) eine solche Steuerung (12) anschließbar ist.
32. Elektronisches Bauelement (1) nach einem der vorangehenden Aspekte, wobei das elektronische Bauelement (1) zumindest teilweise matrixartig ansteuerbar ist.
33. Elektronisches Bauelement (1) nach einem der vorangehenden Aspekte,
   wobei die ersten und zweiten Leiterbahnen (4, 5) der Anode und Kathode einer Matrixschaltung entsprechen.
34. Elektronisches Bauelement (1) nach einem der vorangehenden Aspekte,
   wobei die Befestigungsbereiche (3) auf dem Trägermaterial (2) in einer chaotischen Anordnung positioniert sind.
35. Elektronisches Bauelement (1) nach einem der vorangehenden Aspekte,
   wobei die Befestigungsbereiche (3) auf dem Trägermaterial (2) in Zeilen (Zi) und Spalten (Si) unterteilt sind und/oder zeilen- und spaltenweise ansteuerbar sind.
36. Elektronisches Bauelement (1) nach einem der vorangehenden Aspekte,
   wobei die Befestigungsbereiche (3) gleiche Abstände zueinander, bevorzugt gleichmäßige Abstände im Bereich von 1 mm bis 4 cm, aufweisen, und/oder wobei die Befestigungsbereiche (3) Abstände im Bereich von 1 mm bis 4 cm zueinander aufweisen.
37. Elektronisches Bauelement (1) nach Aspekt 35 oder 36, wobei die Befestigungsbereiche (3) derart angeordnet sind, dass die Befestigungsbereiche (3) einer Spalte (Si) mit der gleichen zweiten Leiterbahn (5) verbunden sind, und/oder dass die Befestigungsbereiche (3) einer Zeile (Zi) mit dergleichen mindestens einen ersten Leiterbahn (4) verbunden sind.
38. Elektronisches Bauelement (1) nach einem der vorangehenden Aspekte, wobei der mindestens eine Leiterbahnstammbereich (6) mindestens einen Befestigungsbereich (3) aufweist.
39. Elektronisches Bauelement (1) nach einem der vorangehenden Aspekte,
   wobei im Randbereich des Trägermaterials (2) mindestens zwei Leiterbahnstammbereiche (6), vorzugsweise auf gegenüberliegenden Seiten des Trägermaterials (2), vorgesehen sind, und
   wobei die ersten und zweiten Leiterbahnen (4, 5) vorzugsweise jeweils mit beiden Leiterbahnstammbereichen (6) verbunden sind.
40. Elektronisches Bauelement (1) nach einem der vorangehenden Aspekte, wobei das Bauelement mindestens zwei Anschlussbereiche aufweist.
41. Elektronisches Bauelement (1) nach einem der vorangehenden Aspekte, wobei der Abstand zweier der Leiterbahnastabschnitte 4a, 5a, die einen Leiterbahnäst 7 und/oder einen Leiterbahnstamm 6 ausbilden um ein Vielfaches, vorzugsweise das geringer ist als der Abstand mindestens zweier sich benachbart zu einander erstreckender Leiterbahnäste 7.
42. Elektronisches Bauelement (1) nach einem der vorangehenden Aspekte,
   wobei die verschiedenen Äste 7 im in etwa gleichen Winkel zum Leiterbahnstammbereich und/oder vorzugsweise parallel zueinander verlaufen.
43. Elektronisches Bauelement (1) nach einem der vorangehenden Aspekte,
   wobei die verschiedenen Äste 7 nicht im in etwa gleichen Winkel zum Leiterbahnstammbereich und/oder vorzugsweise nicht parallel zueinander verlaufen.
44. Elektronisches Bauelement (1) nach einem der vorangehenden Aspekte,
   wobei sich die verschiedenen Äste 7 in verschiedene Richtungen erstrecken.
45. System oder Array von elektronischen Bauelementen (1), aufweisend eine Kombination aus mehreren elektronischen Bauelementen (1) nach einem der vorangehenden Aspekte.
46. Verfahren zur Herstellung eines geometrisch individualisierten elektronischen Bauelementes, oder eines geometrisch individualisierten System von elektronischen Bauelementen, umfassend folgende Schritte:
   Bereitstellen von mindestens einem elektronischen Bauelement nach einem der Aspekte 1 bis 44, und
   Anpassen des mindestens einen elektronischen Bauelements an eine gewünschte individuelle Bauteilgeometrie durch Kombination mehrerer elektronischer Bauelemente und/oder Umformung des Bauelement-Trägermaterials umfassend das Durchtrennen von Bereichen des Bauelements entlang einer oder mehrerer Trennlinien und/oder Separation von mindestens einem Ablängbereich umfassend mindestens einen Befestigungsbereich.
47. Verfahren nach Aspekt 46, wobei der mindestens eine Ablängbereich durch Schneiden, Reißen, oder Brechen separiert wird und/oder wobei das Durchtrennen durch Schneiden, Reißen, oder Brechen, vorzugsweise manuell, erfolgt.
48. Verfahren nach Aspekt 46 oder 47, wobei der mindestens eine Ablängbereich derart separiert wird, dass die ersten und zweiten Leiterbahnen der Leiterbahnäste und/oder Leiterbahnzweige und/oder Leiterbahnunterzweige des elektronischen Bauelements weiterhin mit dem mindestens einem Anschlusselement verbunden sind.
49. Verfahren nach Aspekt 46, 47 oder 48, wobei das Separieren entlang der mindestens einen Trennlinie eines Trennbereiches und/oder entlang mindestens einer Ablänglinie zum Durchtrennen von mindestens einer ersten und mindestens einer zweiten Leiterbahn erfolgt.
50. Verfahren zur Herstellung von zwei geometrisch individualisierbaren Bauelementen nach Aspekt 39, umfassend mindestens folgende Schritte:
   Bereitstellen von mindestens einem elektronischen Bauelement nach Aspekt 39, und
   Auftrennung des Trägermaterials in mindestens zwei Teile, wobei jeder Teil einen Anschlussbereich aufweist und funktionsfähig ist.
51. Verwendung eines Bauelements nach einem der Aspekte 1 bis 44 zur Herstellung eines individualisierten Bauelements, vorzugsweise gemäß einem Verfahren nach einem der Aspekte 46 bis 50.

Nachfolgend werden die Merkmale und Vorteile der vorliegenden Erfindung anhand bevorzugter Ausführungsformen unter Bezugnahme auf die Figuren näher erläutert. Dabei zeigen
Fig. 1 eine herkömmliche Leiterbahnanordnung zur Matrixschaltung nach dem Stand der Technik, wobei Fig. 1A eine solche Leiterbahnanordnung unter Verwendung einfacher LEDs und Fig. 1B eine solche Anordnung unter Verwendung von RGB-LEDs zeigt;
Fig. 2 zeigt eine Leiterbahnanordnung gemäß der vorliegenden Erfindung mit einem Leiterbahnstamm bzw. Leiterbahnstammbereich, mehreren Leiterbahnästen sowie einem Anschlussbereich;
Fig. 3 zeigt ein entsprechendes elektronisches Bauelement gemäß Fig. 2 mit einer solchen Leiterbahnanordnung;
Fig. 4 zeigt ein erfindungsgemäßes Bauelement mit einer bevorzugten Leiterbahnanordnung gemäß einer bevorzugten Ausführungsform, wobei Fig. 4A die Leiterbahnanordnung des Bauelements zeigt und Fig. 4B bevorzugte Trenn- und Ablängbereiche hervorhebt;
Fig. 5 zeigt eine bevorzugte Ausführungsform eines erfindungsgemäßen Bauelements mit zwei Anschlussbereichen;
Fig. 6 zeigt ein erfindungsgemäßes Bauelement gemäß einer bevorzugten Ausführungsform mit einer sternförmiger Leiterbahnstruktur und seitlichem angeordnetem Anschlussbereich;
Fig. 7 zeigt eine bevorzugte Ausführungsform eines erfindungsgemäßen Bauelements mit sternförmiger Leiterbahnstruktur und mittig angeordnetem Anschlussbereich in zwei unterschiedlichen Leiterbahnkonfigurationen (Fig. 7A und 7B);
Fig. 8 zeigt eine bevorzugte Ausführungsform eines Arrays aufweisend eine Vielzahl (verschiedener) erfindungsgemäßer Bauelemente;
Fig. 9 zeigt eine alternative Ausführungsform eines erfindungsgemäßen Bauelements, wobei Fig. 9A den Verlauf der Leiterbahnen darstellt und Fig. 9B die Abläng- bzw. Trennbereiche des entsprechenden Bauelements hervorhebt;
Fig. 10 zeigt eine weitere alternative bevorzugte Ausführungsform eines erfindungsgemäßen Bauelements;
Fig. 11 zeigt einen Aufbau wie er in der Figur 2 gezeigt ist, wobei die verschiedenen ersten und zweiten Leiterbahnen 4, 5 in verschiedenen Ebenen übereinander angeordnet sind;
Fig. 12 zeigt eine Schnittdarstellung entlang der Linie A-A der Figur 11;
Fig. 13 zeigt eine Schnittdarstellung entlang der Linie B-B der Figur 11.

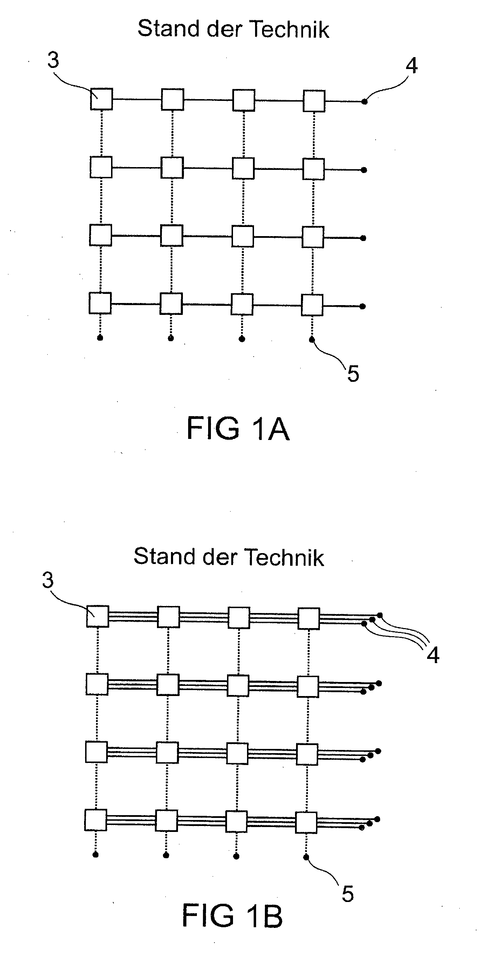

Fig. 1A zeigt eine schematische Darstellung einer LED-Matrix, also einer zeilenspaltenweisen Anordnung mehrerer LEDs, wobei die Leiterbahnanordnung gemäß einer Matrixschaltung ausgebildet ist. Jeder der Verbraucher bzw. jede LED 3 ist mit jeweils einer ersten Leiterbahn 4 und einer zweiten Leiterbahn 5 verbunden, wobei jede LED mit einer anderen ersten oder zweiten Leiterbahn 5 verbunden ist. Üblicherweise werden hierbei alle Pluspole bzw. Anoden 4 der Verbraucher bzw. LED zeilenweise verbunden während alle Minuspole bzw. Kathoden 5 spaltenweise verbunden sind. Sobald nun an eine Spalte und eine Zeile Strom und Masse angelegt werden, beginnt der Strom durch den Verbraucher bzw. die LED zu fließen, der bzw. die im Schnittpunkt der angeschlossenen Zeile und Spalte liegt. Es sind besondere Ausführungen der Ansteuerung bekannt, bei denen im Rahmen einer Matrixschaltung einzelne Verbraucher intermittierend für begrenzt aufeinander folgende Zeitfenster oder mit variierenden Intensitäten angesteuert werden, um beispielsweise gewünschte Helligkeiten oder Farbnuancen zu erzeugen. Die Spalten werden vorzugsweise im Multiplexing-Verfahren betrieben bzw. angesteuert.

Fig. 1B zeigt eine entsprechende Verwendung von RGB-LED. RGB-LED erlauben als einzelnes Bauelement die Widergabe von rotem, grünem und/oder blauem Licht. Hierzu bedarf es jedoch pro LED drei der ersten Leiterbahnen bzw. Anoden 4, von denen jeweils eine für rotes, grünes und blaues Licht vorgesehen ist. Die jeweiligen Farben können sowohl einzeln als auch gemeinsam angesteuert werden. Alternativ können die Kathoden 5 anstelle der Anoden 4 dreifach geführt sein.

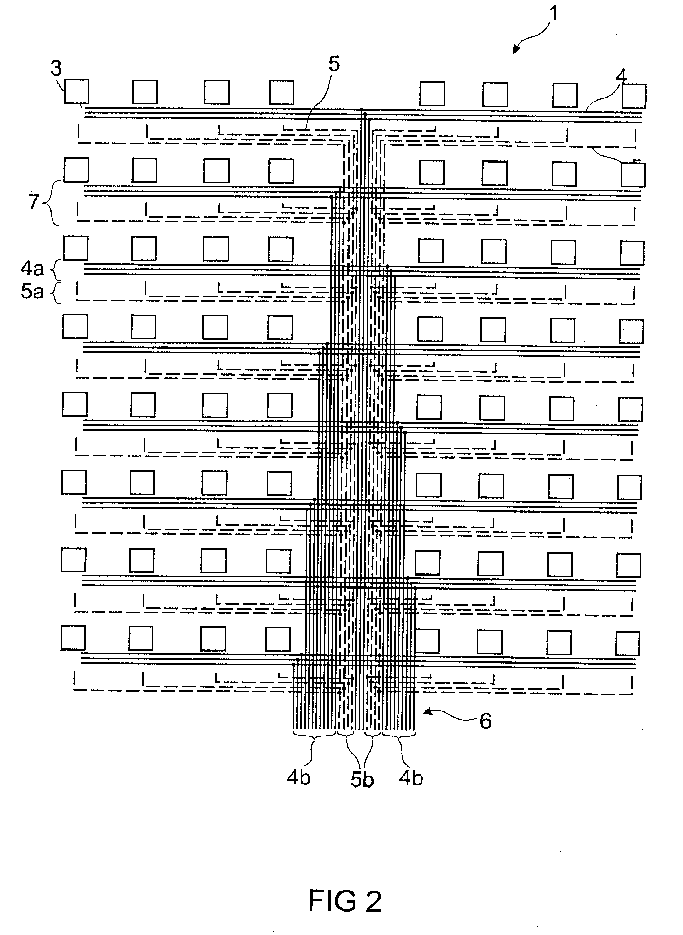

Fig. 2 zeigt eine bevorzugte erfindungsgemäße Ausgestaltung einer Leiterbahnanordnung mit mehreren Verbrauchern, hier RGB-LEDs. Dabei sind die Leiterbahnen 4, 5 bzw. Kathoden 5 und Anoden 4 nicht, wie im Stand der Technik bekannt, zeilen- und spaltenweise angeordnet. Dennoch erlaubt die erfindungsgemäße Leiterbahnanordnung eine Matrixansteuerung der LEDs. Die erfindungsgemäße Anordnung weist erste Leiterbahnen bzw. Anoden 4 und zweite Leiterbahnen bzw. Kathoden 5 auf. In der Darstellung gemäß Fig. 2 sind die ersten Leiterbahnen bzw. Anoden 4 als durchgezogene Linie dargestellt, wohingegen die zweiten Leiterbahnen bzw. Kathoden 5 gestrichelt wiedergegeben sind. Die ersten 4 und zweiten 5 Leiterbahnen gemäß der erfindungsgemäßen Ausbildung bilden eine sogenannte Baumstruktur. Hierzu weist eine erste Leiterbahn 4 einen ersten Leiterbahnstammabschnitt 4b, der sich in der Darstellung gemäß Fig. 2 spaltenartig bzw. in senkrechter Richtung erstreckt, sowie einen ersten Leiterbahnastabschnitt 4a, der sich in der Darstellung gemäß Fig. 2 zeilenartig bzw. horizontal erstreckt. Astabschnitt 4a erstreckt sich in der dargestellten bevorzugten Ausführungsform winkelig zum ersten Leiterbahnstammabschnitt 4b, und zwar in einem Winkel vorzugsweise etwa 90°. Gemäß anderen Ausführungsformen sind für den Fachmann erkennbar auch andere Winkel realisierbar, wie beispielsweise im Bereich von etwa 20° bis 160°. Ebenso weist eine zweite Leiterbahn 5 einen zweiten Leiterbahnstammabschnitt 5b, der sich ebenso wie der erste Leiterbahnstammschnitt 4b im Wesentlichen senkrecht erstreckt, sowie einen zweiten Leiterbahnastabschnitt 5a auf, der sich im Wesentlichen horizontal erstreckt. Ebenso wie im Zusammenhang mit der ersten Leiterbahn diskutiert, erstreckt sich der zweite Leiterbahnerstabschnitt 5a vorzugsweise in einem Winkel, vorzugsweise von etwa 20° bis 120° und besonders bevorzugt von etwa 90°, zum zweiten Leiterbahnstammabschnitt 5b. Die Leiterbahnstammabschnitte 5b, 4b der ersten 4 und zweiten 5 Leiterbahnen sind vorzugsweise im Wesentlichen parallel zueinander angeordnet bzw. erstrecken sich im Wesentlichen in die gleiche Richtung und bilden einen Leiterbahnstammbereich 6 aus. Vorzugsweise sind die ersten und zweiten Leiterbahnstammabschnitte 4b, 5b benachbart zueinander und in geringem Abstand zueinander angeordnet. Wie ersichtlich ist der Abstand zwischen Leiterbahnabschnitten eines Bereiches (bspw. Ast, Stamm) um ein vielfaches geringer als zwischen sich nicht entsprechenden Bereichen. So erstrecken sich auch die ersten und zweiten Leiterbahnastabschnitte 4a, 5a.

In der bevorzugten Ausführungsform gemäß Fig. 2 sind die Verbraucher als RGB-LED ausgebildet, sodass jeder Verbraucher über drei Anoden 4 (rot, grün, blau) bzw. erste Leiterbahnen 4 angesteuert bzw. mit ihnen verbunden ist. Jede RGB-LED ist weiterhin mit jeweils einer Kathode bzw. zweiten Leiterbahn 5 verbunden. Es können jedoch auch einfache LED oder andere Leuchtmittel verwendet werden.

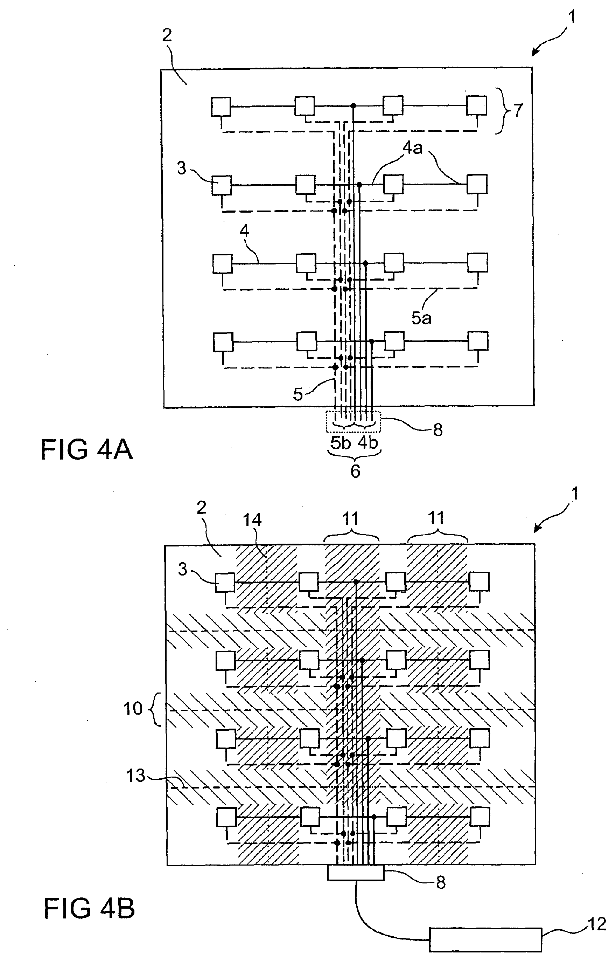

Aufgrund des vorteilhaften und bevorzugten Verlaufs der Leiterbahn gemäß der vorliegenden Erfindung, wie in Fig. 2 gezeigt, ergeben sich zwischen den einzelnen Leiterbahnen erste Trennbereiche 10 (in Fig. 2 nicht dargestellt; vgl. Fig. 4B), in denen keine Leiterbahn 4, 5 verläuft. Das Trägermaterial kann somit entlang dieser Trennbereiche 10 bzw. entlang durch diese verlaufende imaginäre Trennlinien 13 (in Fig. 2 nicht dargestellt; vgl. Fig. 4B) eingeschnitten werden, insbesondere ohne eine Leiterbahn 4, 5 zu durchtrennen, wie einleitend diskutiert. Dies erlaubt es, einzelne Leiterbahnäste 7 sowie das sie umgebende Trägermaterial ganz oder teilweise vom elektronischen Bauelement 1 und dem verbleibenden Trägermaterial zu separieren und geometrisch gegenüber diesem zu verformen, sei es durch Abknicken oder Biegen etc. Dabei bleibt die Verbindung der ersten und zweiten Leiterbahnastabschnitte 4a, 5b des jeweiligen Leiterbahnastes 7 mit dem jeweiligen ersten und zweiten Leiterbahnstammabschnitt 4b, 5b bzw. dem Stammbereich 6 erhalten, so dass die (Matrix-)Ansteuerbarkeit der LED des jeweiligen Leiterbahnastes 7 vollständig erhalten bleibt.

Alternativ oder zusätzlich erlaubt die erfindungsgemäße Ausbildung das Schaffen von Ablängbereichen 11 (in Fig. 2 nicht hervorgehoben; vgl. Fig. 4B). Die Ablängbereiche erlauben das Abtrennen mehrerer Leuchtmittel eines oder mehrerer Leiterbahnäste 7, insbesondere vom Rand des elektronischen Bauelements her, wobei die Funktionalität und Ansteuerbarkeit der verbleibenden Leuchtmittel 3 unbeeinträchtigt bleibt. Das Abtrennen erfolgt vorzugsweise entlang zumindest einer (imaginären) Abläng- bzw. Abtrennlinie 14 (in Fig. 2 nicht hervorgehoben; vgl. Fig. 4B).

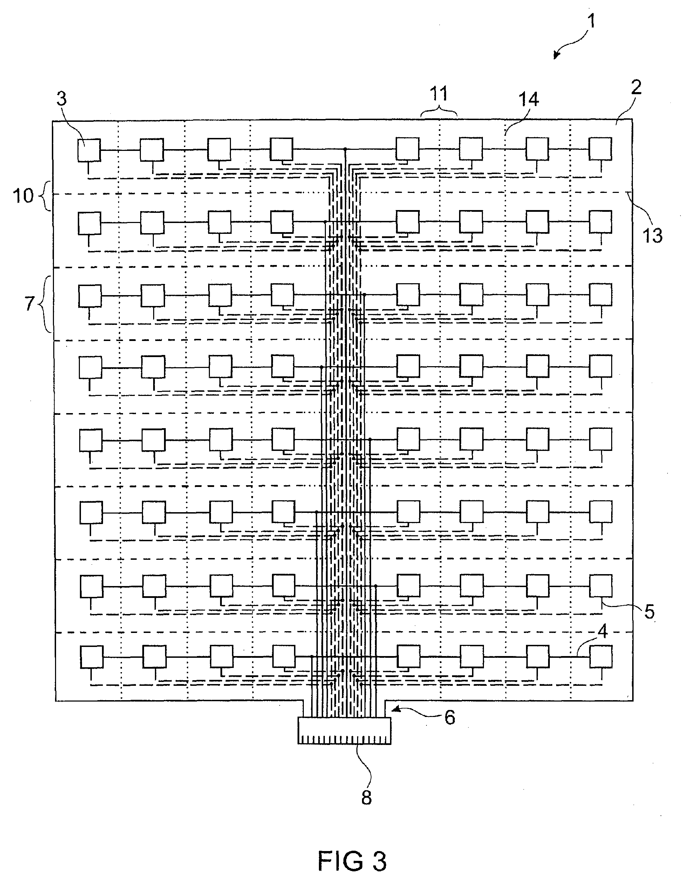

Fig. 3 zeigt eine entsprechende Ausführungsform mit mehreren, in Zeilen und Spalten angeordneten Verbrauchern, vorzugsweise LED. In Fig. 3 sind imaginäre Trennlinien 13 der Trennbereiche 10 gestrichelt dargestellt, wohingegen die imaginären Ablänglinien 14 der Ablängbereiche gepunktet dargestellt sind. Ein Trennbereich 10 erstreckt sich somit vorzugsweise entlang bzw. zwischen einzelnen Leiterbahnästen 7, wobei ein Durchtrennen des Trägermaterials entlang eines Trennbereichs 10 bzw. einer Trennlinie 13 keine Leiterbahn 4, 5 schneidet bzw. eine solche nicht durchtrennt. Dahingegen kreuzen Ablänglinien 14 der Ablängbereiche 11 notwendigerweise eine oder mehrere Leiterbahnen 4, 5, um ein Abtrennen einzelner Abschnitte des Trägermaterials mit einem und vorzugsweise mehreren Befestigungsbereichen oder LED 3 zu erlauben. Die Trennbereiche 10 können entlang von Trennlinien 13 bereits bei der Herstellung vorgeschnitten werden oder aber zum Durchtrennen vorbereitet sein, beispielsweise durch Perforation oder andere Sollbruchstellen. Dies erlaubt eine einfache Variation der Leiterplatte. Sie können aber auch nicht weiter vorbereitet sein, was die Variabilität der späteren Gestaltungsmöglichkeiten erhöht.

Das elektronische Bauelement bzw. Trägermaterial kann dann nach der Herstellung durch den Verbraucher durch Ablängen einzelner LED zusammen mit dem diese umgebenden Trägermaterial abgelängt bzw. abgetrennt werden. Ein derartiges Ablängen bzw. Abtrennen erfolgt vorzugsweise durch Durchtrennen des Trägermaterials ausgehend vom Randbereich entlang einer Trennlinie 13 und/oder einer Ablänglinie 14. Hier sei zu beachten, dass der Stammbereich der dargestellten Ausführungsform einmal durchtrennt werden kann. Die abseits des Anschlussbereichs mit dem Stammbereich verbundenen Leiterbahnäste 7 bzw. LED 3 können dann nicht mehr angesteuert werden, wohingegen die verbleibenden Leuchtmittel bzw. LED weiterhin uneingeschränkt ihrer ursprünglichen Ansteuerung gemäß ansteuerbar nutzbar sind. Alternativ oder zusätzlich können mehrere Leuchtmittel durch Durchtrennen des Trägermaterials entlang von mindestens einer, vorzugsweise mindestens zwei, Trennlinien 10 räumlich durch bspw. Abknicken, Biegen oder dgl. gegenüber dem übrigen Trägermaterial positioniert werden.

Fig. 4A zeigt eine vergleichbare bevorzugte Ausführungsform, bei der die ersten und zweiten Leiterbahnstammabschnitte 4b, 5b im Leiterbahnstammbereich 6 gruppiert verlaufen. Die ersten Leiterbahnstammabschnitte 4b sind dabei unmittelbar benachbart zueinander angeordnet und die zweiten Leiterbahnstammabschnitte 5b sind unmittelbar benachbart zueinander angeordnet. Fig. 4A zeigt zudem die bevorzugte Ausbildung eines Anschlussbereichs 8, in dem eine Mehrzahl der, vorzugweise die meisten bzw. alle, ersten und zweiten Leiterbahnen 4, 5 räumlich dicht beieinander zusammengeführt werden, um eine einfache und effektive Ansteuerung bzw. Anschlussmöglichkeit für das erfindungsgemäße elektronische Bauelement 1 zu gewährleisten. Die Ausbildung des Leiterbahnstammbereichs 6 und der Leiterbahnäste 7 durch erste und zweite Leiterbahnen 4, 5 bzw. deren Leiterbahnast- und Stammabschnitte entspricht der vorstehenden Diskussion.

Fig. 4B zeigt zudem das elektronische Bauelement gemäß Fig. 4A in Verbindung mit einer am Anschlussbereich 8 angeschlossenen Steuerung 12. Fig. 4B zeigt weiterhin verschiedene bevorzugte Trennbereiche 10 der Ausführungsform gemäß Fig. 4A in Verbindung mit verschiedenen bevorzugten Ablängbereichen 11. Die Trennbereiche 10 und Ablängbereiche 11 sind durch unterschiedliche Schraffuren hervorgehoben und weisen jeweils mindestens eine gestrichelt dargestellte Trennlinie 13 sowie eine gepunktet dargestellte Ablänglinie 14 auf. Während die Trennlinien 13 keine Leiterbahn kreuzen, kreuzen die Ablänglinien 14 regelmäßig Leiterbahnen, die beim Abtrennen einzelner Bereiche bzw. Abschnitte des elektronischen Bauelements 1 durchtrennt werden.

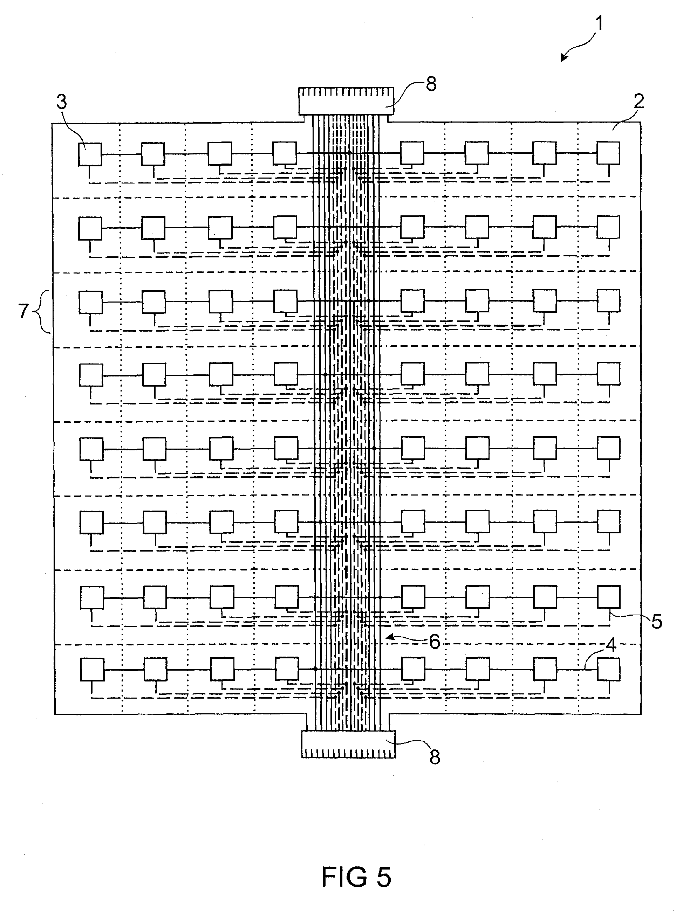

Fig. 5 zeigt eine bevorzugte erfindungsgemäße Ausführungsform, bei der ein elektronisches Bauelement 1 einen Leiterbahnstammbereich 6 mit zwei gegenüberliegenden Anschlussbereichen 8 aufweist. Hierbei ist jeder den Leiterbahnstammbereich 6 bildende erste und zweite Leiterbahnstammabschnitt 4b, 5b vorzugsweise mit jedem der beiden Anschlussbereiche 8 verbunden. Dies erlaubt eine vollständige Durchtrennbarkeit des Leiterbahnstammbereichs 6 derart, dass eine solche Durchtrennung zu zwei jeweils vollständig unabhängig voneinander nutzbaren bzw. steuerbaren elektronischen Bauelementen 1 führt.

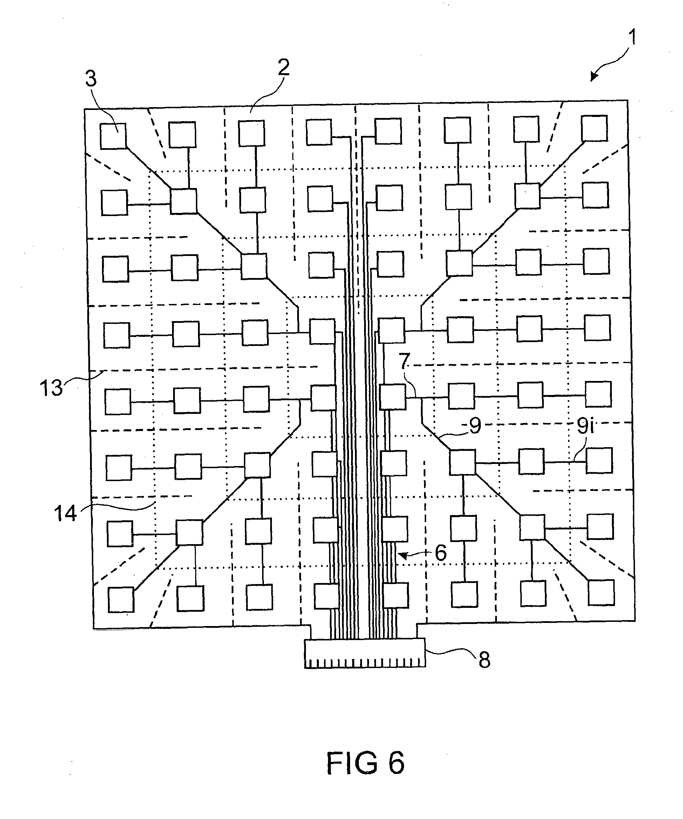

Fig. 6 zeigt eine weitere erfindungsgemäße Ausgestaltung eines elektronischen Bauelements 1, wobei die Leiterbahnen 4, 5 sternartig aufgebaut bzw. angeordnet sind. Hierbei verlaufen die verschiedenen Äste 7 nicht im gleichen Winkel zum Leiterbahnstammbereich, sondern erstrecken sich in verschiedene Richtungen. Fig. 6 zeigt zudem die bevorzugte erfindungsgemäße Ausbildung von Leiterbahnzweigen 9, die sich von Leiterbahnästen 7 winkelig erstrecken bzw. in welche sich Leiterbahnäste 7 aufteilen. Eine derartige Untergliederung ist für den Fachmann erkennbar auch bei anderen geometrischen Leiterbahnanordnungen der vorliegenden Erfindung denkbar. Im Einklang mit der Diskussion der voranstehenden bevorzugten Ausführungsformen weist auch die sternförmige Leiterbahnanordnung gemäß Fig. 6 verschiedene Trennbereiche 10 und Ablängbereiche 11 auf, die Trennlinien 13 bzw. Ablänglinien 14 umfassen. Wie bereits oben zum Ausdruck gebracht, sind Trenn- und/oder Ablänglinien imaginäre Linien, wobei diese auch auf dem Trägermaterial gekennzeichnet werden können oder aber als Sollbruchstellen ausgebildet sein können. Die Leiterbahnen 4, 5 sind in Fig. 6 schematisch dargestellt.

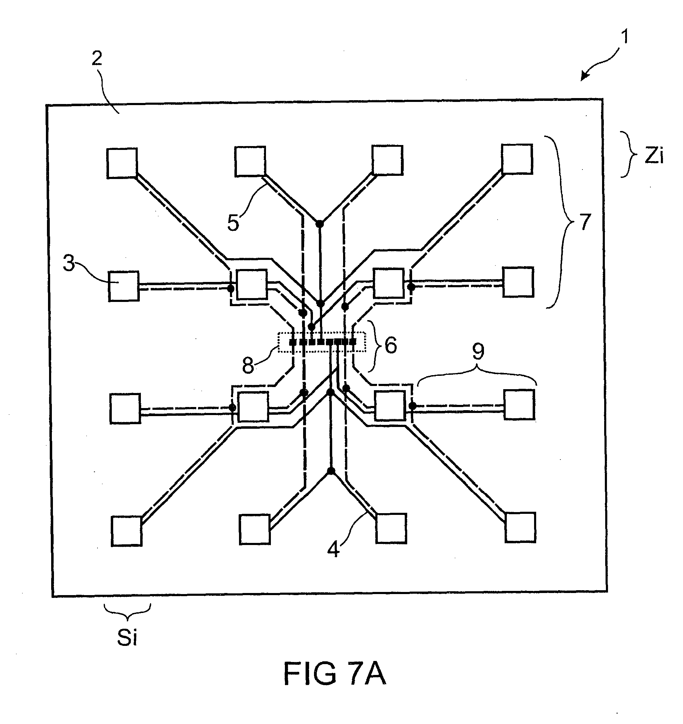

Fig. 7A zeigt ebenfalls eine bevorzugte erfindungsgemäße Ausführungsform mit sternförmigem Leiterbahnverlauf, bei der der Anschlussbereich 8 in der Mitte des elektronischen Bauelements 1 angeordnet ist. Hierdurch kann ein bzw. mehrere vergleichsweise kürzere Leiterbahnstammbereiche 6 entstehen, von dem bzw. von denen sich Leiterbahnäste 7 erstrecken, die wiederum Leiterbahnzweige 9 und Unterzweige 9i umfassen können. Wie aus Fig. 7A ersichtlich, können Leiterbahnen 4, 5 auch mehrere Knicke, Radien oder dergleichen aufweisen.

In Fig. 7A sind die Befestigungsbereiche 3 in vier Zeilen Zi und vier Spalten Si unterteilt. Sie sind dabei zeilen- und spaltenweise ansteuerbar. Die Befestigungsbereiche 3 sind derart angeordnet, dass die Befestigungsbereiche 3 einer Spalte Si mit der gleichen zweiten Leiterbahn 5 verbunden sind, und die Befestigungsbereiche 3 einer Zeile Zi sind mit der gleichen ersten Leiterbahn 4 verbunden. Mit anderen Worten sind die Anschlüsse im Anschlussbereich 8 mit ersten Leiterbahnen 4 verbunden, die wiederum jeweils mit LEDs einer gemeinsamen Zeile Zi verbunden sind, oder mit zweiten Leiterbahnen 5, die wiederum jeweils mit LEDs einer gemeinsamen Spalte Si verbunden sind. Zur Vereinfachung sind hier einfarbige LEDs gezeigt. Selbstverständlich ist das Prinzip auch auf die Leiterbahnführung von mehrfarbigen LEDs anwendbar.

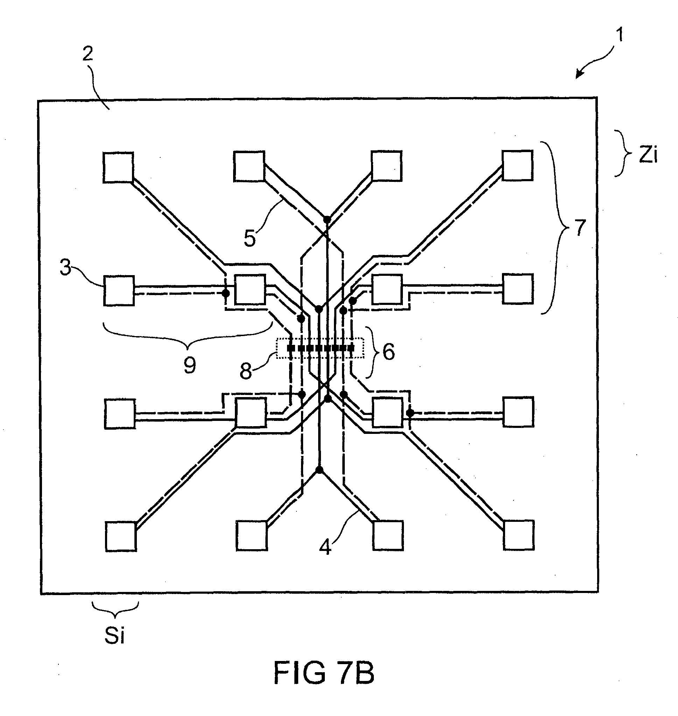

Fig. 7B zeigt eine Ausführungsform, in der die Befestigungsbereiche 3 ebenfalls in vier Zeilen Zi und Spalten Si unterteilt sind, und die auch zeilen- und spaltenweise ansteuerbar sind. Im Gegensatz zur Anordnung der Fig. 7A sind in dieser Ausführungsform die einzelnen Befestigungsbereiche 3 anders verschaltet bzw. sind die Leiterbahnen anders geführt, ohne jedoch die erfindungsgemäße Struktur aufzugeben. Die Befestigungsbereiche 3 einer Spalte Si sind dabei beispielsweise über zwei unterschiedliche Leiterbahnen 5 mit dem Anschlussbereich 8 verbunden, und die Befestigungsbereiche 3 einer Zeile Zi sind über zwei unterschiedliche ersten Leiterbahnen 4 mit dem Anschlussbereich 8 verbunden. Mit anderen Worten sind die Anschlüsse im Anschlussbereich 8 mit einer ersten Leiterbahn 4 verbunden, die wiederum mit LEDs von unterschiedlichen Zeilen Zi verbunden ist, oder mit einer zweiten Leiterbahn 5, die wiederum mit LEDs unterschiedlicher Spalten Si verbunden ist. Die ersten und/oder zweiten Leiterbahnen 4, 5 sind dabei vorteilhaft so verlegt bzw. so angeordnet, dass die Leiterbahnlängen der ersten und/oder zweiten Leiterbahnen 4, 5 möglichst kurz sind. Dadurch reduziert sich bei gleicher Anordnung der Befestigungsbereiche 3 die Gesamtleiterbahnlänge.

Bei einem solchen Layout wird durch geeignete Maßnahmen, beispielsweise mittels einer entsprechend eingerichteten Steuerung, gewährleistet, dass zum Ansteuern der LEDs einer Zeile Zi an die LEDs über die entsprechenden ersten und/oder zweiten Leiterbahnen 4, 5 Spannung angelegt wird. Bei der Konfiguration gemäß der Fig. 7A würde im Gegensatz zur Fig. 7B zum Ansteuern der LEDs einer Zeile Zi lediglich mittels einer einzigen ersten Leiterbahn 4 und mittels mehrerer zweiten Leiterbahnen 5 eine Spannung angelegt. Beide Ausführungen erlauben eine Matrixansteuerung der Befestigungsbereiche bzw. LED. Sie sind daher als elektrisch äquivalent anzusehen.

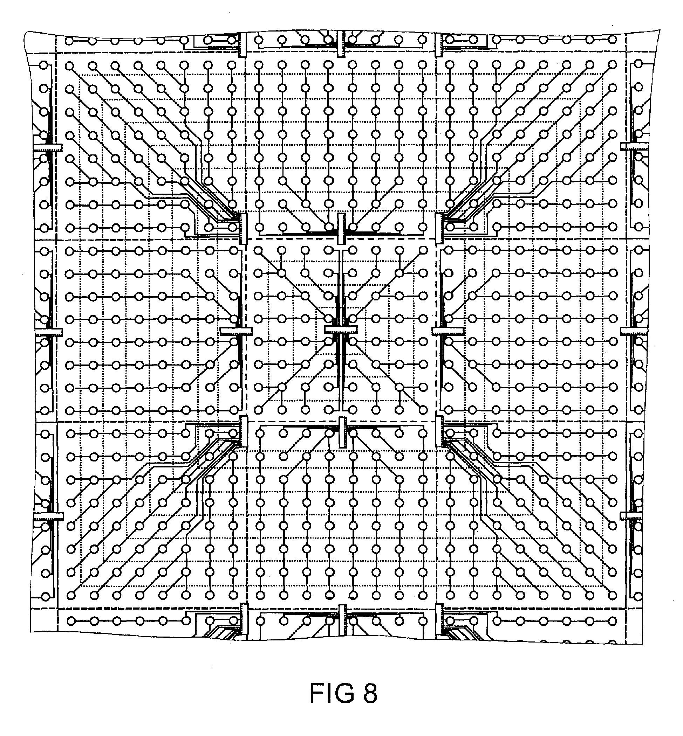

Gemäß einer bevorzugten erfindungsgemäßen Ausführungsform, wie in Fig. 8 dargestellt, sind mehrere erfindungsgemäße Bauelemente kombinierbar, insbesondere ein resultierendes elektronisches Bauelement mit größerer Fläche zu bilden. Hierbei werden bevorzugt verschiedene erfindungsgemäße Bauelemente verwendet, wie in Fig. 8 gezeigt. Die Leiterbahnen sind hier schematisch dargestellt.

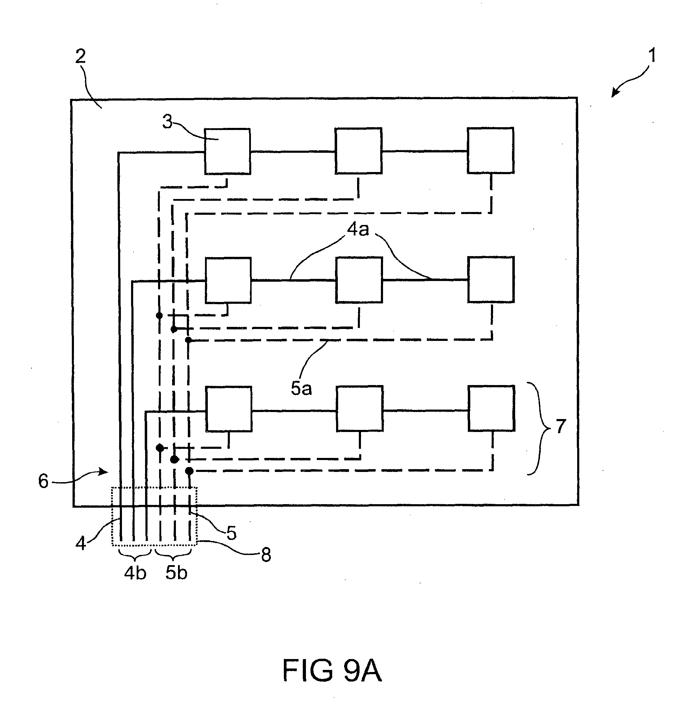

Fig. 9A zeigt eine bevorzugte erfindunsgemäße Ausführungsform, bei der sich Leiterbahnäste 7 ausgehend vom Leiterbahnstammbereich 6 lediglich in eine Richtung, in der Darstellung nach rechts, erstrecken. Hierbei ist der Anschlussbereich 8 vorzugsweise im Eck- bzw. Randbereich einer Seite eines, vorzugsweise im Wesentlichen rechteckigen, elektronischen Bauelements bzw. Trägermaterials angeordnet.

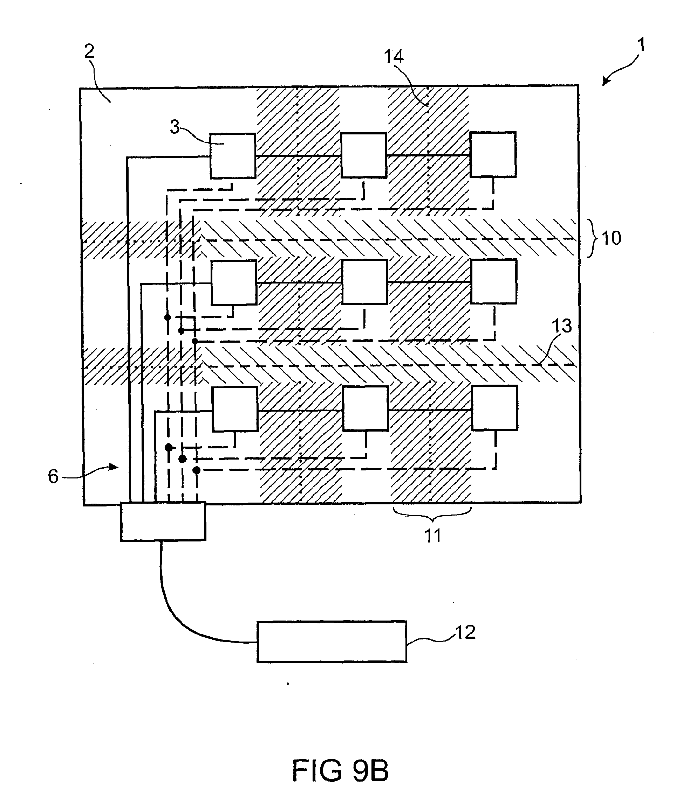

Fig. 9B zeigt eine entsprechende Ausgestaltung, zusätzlich mit einer bevorzugten Steuerung 12, wobei die Trennbereiche 10 mit Trennlinien 13 und Ablängbereiche 11 mit Ablänglinien 14 hervorgehoben sind.

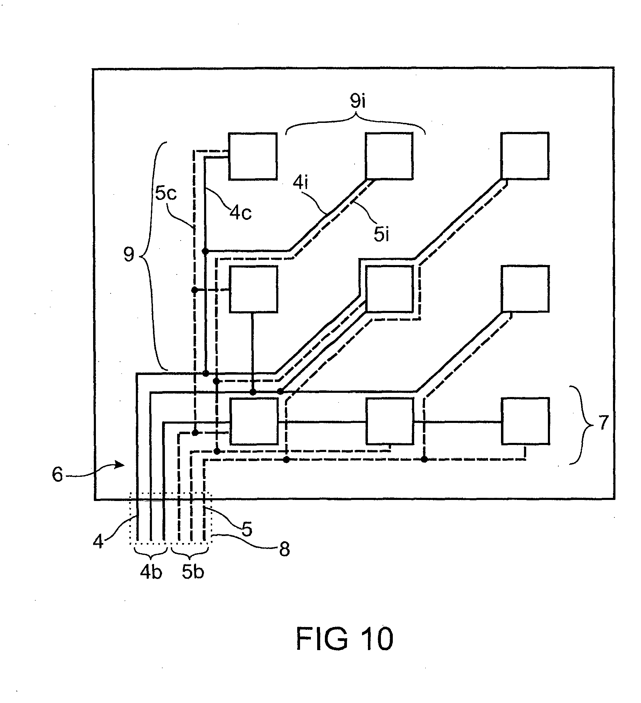

Fig. 10 zeigt eine weitere alternative erfindungsgemäße Ausführungsform, bei der der Anschlussbereich 8 des Leiterbahnstammbereichs 6 im Eckbereich einer im Wesentlichen rechteckigen Bauelementstruktur befindet und wobei sich die Leiterbahnäste, Zweige und/oder Unterzweige etc. in unterschiedlichen Winkeln vom Leiterbahnstammbereich 6 erstrecken.

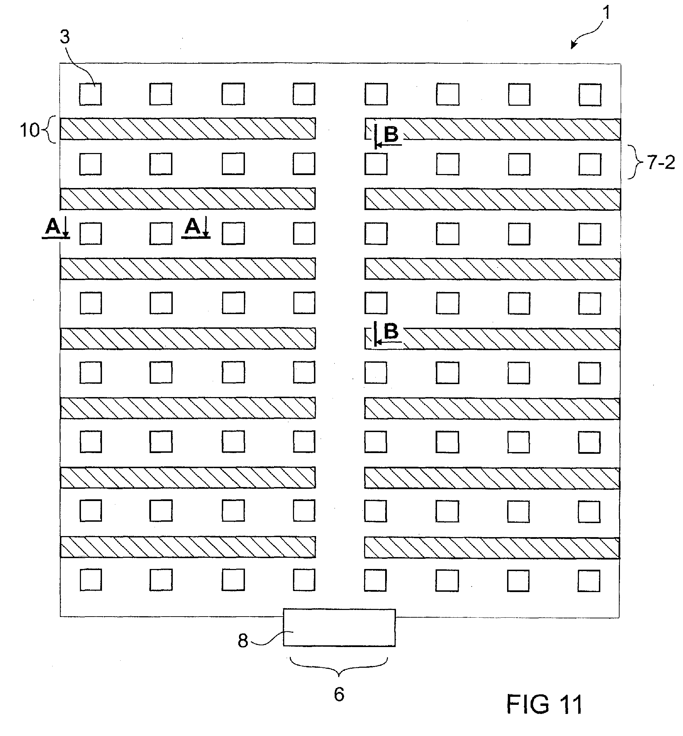

Fig. 11 zeigt einen schematischen Aufbau wie er in der Figur 2 gezeigt ist, wobei verschiedene erste und zweite Leiterbahnen 4, 5 in verschiedenen Ebenen übereinander angeordnet sind. Zwischen den einzelnen Leiterbahnästen 7 verlaufen jeweils Trennbereiche 10.

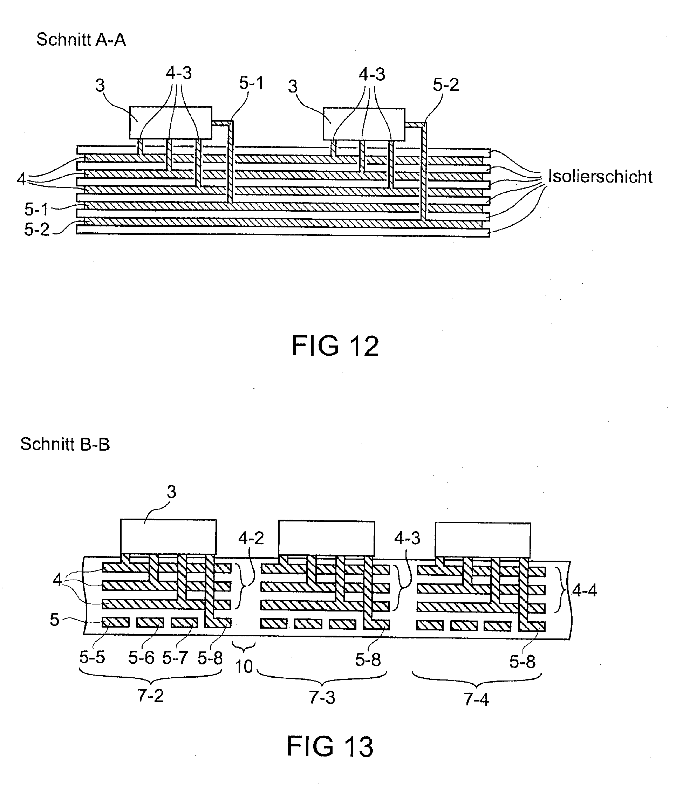

Fig. 12 zeigt eine schematische Schnittdarstellung entlang der Linie A-A der Figur 11 in der zwei RGB-LEDs dargestellt sind. Die drei gemeinsamen ersten Leiterbahnen bzw. Anoden 4-3 sind an beide LEDs jeweils durchkontaktiert und die zwei verschiedenen zweiten Leiterbahnen bzw. Kathoden 5-1, 5-2 sind jeweils zu den verschiedenen Anschlüssen 5-1, 5-2 jeweils einer LED durchkontaktiert. Wie aus dieser Ansicht ersichtlich ist, entsteht ein schichtartiger Aufbau mit verschiedenen, vorzugsweise parallelen, Lagen. Die einzelnen Leiterbahnen sind jeweils durch Isolierungen bzw. Isolierschichten voneinander getrennt. Die Leiterbahnen sind hier als durchgängig (von links nach rechts) dargestellt, könnten jedoch auch auf die zum Anschluss der jeweiligen Befestigungsbereiche bzw. LED Länge bzw. Erstreckung begrenzt sein.

Fig. 13 zeigt eine schematische Schnittdarstellung entlang der Linie B-B der Figur 11, die etwa senkrecht zum Schnitt A - A verläuft. Die drei zweiten Leiterbahnen bzw. Kathoden 5-8 der drei Leiterbahnäste 7 sind jeweils zu einer RGB-LED durchkontaktiert. Während im Schnitt A - A die Kathoden 5-1 und 5-2 übereinander angeordnet sind und bevorzugt eine im Vergleich zu den Kathoden der Figur 2 gesteigerte, vorzugsweise flächige, Leiterbahnbreite aufweisen können, sind die Kathoden 5-5 bis 5-8 im Schnitt B - B exemplarisch ähnlich wie in der Figur 2 in einer Schicht nebeneinander angeordnet. Sie weisen beispielsweise eine herkömmliche, vorzugsweise nicht flächige, Leiterbahnbreite auf. Selbstverständlich könnten die Kathoden im Schnitt B - B auch übereinander verlaufen oder andere Verläufe, wie im Rahmen der Erfindung auch in Bezug auf andere beispielhafte Ausführen genannt, annehmen. Generell sind sämtliche Kombinationen von nebeneinander und/oder übereinander verlaufenden ersten und/oder zweiten Leiterbahnen 4, 5 einsetzbar. Generell können auch Leiterbahnen, die keine gesteigerte Leiterbahnbreite aufweisen, in verschiedenen Ebenen geführt sein. Dies ist vorzugsweise im Stammbereich 6 der Fall. In jedem Leiterbahnast 7 sind jeweils drei Anoden für die RGB Anschlüsse der LEDs vorgesehen, hier schichtweise übereinander angeordnet (vgl. Diskussion Fig. 12) die für die verschiedenen Leiterbahnäste 7-2, 7-3 und 7-4 als Anoden 4-2, 4-3 und 4-4 bezeichnet sind.

Die Breite der drei Anoden eines Leiterbahnastes 7 und/oder die Breite der Kathoden 5-5 bis 5-8 eines Leiterbahnastes 7 kann dabei entsprechend den Rahmenbedingungen gewählt werden. Vorzugsweise sind sie dabei so gewählt, dass die Gesamtbreite des Leiterbahnastes 7 minimal ist. So sind vorteilhaft große Trennbereiche 10 erzielbar. Die notwendige minimale Breite eines Leiterbahnastes 7 ergibt sich durch verschiedene Einflussfaktoren wie beispielsweise Anzahl und Anordnung der eingesetzten LEDs, eingesetzten Leiterbahnmaterialien, Isolatoren, Wärmeübergänge, etc., die einem Fachmann aus herkömmlichen Leiterplattenaufbauten bekannt sind. Wie oben geschildert kann auch eine breite Leiterbahn vorgesehen werden, die in den Trennbereich reicht, wobei diese bei einschneiden in den Trennbereich nicht vollständig, bspw. galvanisch bzw. funktional, getrennt wird, und insbesondere die Funktion von mit der Bahn verbundenen Befestigungsbereichen und bspw. LED nicht beeinträchtigt wird.

Die Breite und Anordnung von nebeneinander und/oder übereinander angeordneter erster und/oder zweiter Leiterbahnen 4, 5 kann nicht nur in den Leiterbahnästen 7, sondern auch in etwaigen Leiterbahnzweigen 9 und/oder etwaigen Leiterbahnunterzweigen 9i so gewählt werden, dass deren Breite bevorzugt in jedem Bereich minimal ist. Die obigen Beispiele finden bevorzugt auch im Stammbereich, in Asten, in Zweigen und/oder Unterzweigen Anwendung.

Gemäß den zuvor beschriebenen Ausführungsformen, wie in den Figuren dargestellt, sind die Leuchtmittel bzw. LED im Wesentlichen symmetrisch bzw. zeilen- und spaltenartig angeordnet. Es sind jedoch auch andere, beispielsweise chaotische, Anordnungen denkbar. Die erfindungsgemäßen Bauelemente erlauben einen vielfältigen variablen Einsatz derselben, ausgehend von einer, insbesondere herstellungstechnisch standardmäßigen, Grundform. So kann das jeweilige Bauelement flächig eingesetzt werden, wobei es seine ursprüngliche Form inne hat oder aber durch Abtrennen einzelner Ablängbereiche unterschiedliche flächige geometrische Grundformen annehmen kann. So können beispielsweise Zahlen, Buchstaben oder andere geometrische Formen zugeschnitten werden. Auch ist es möglich, das Bauelement an die Form des Gegenstandes bzw. der Struktur anzugleichen bzw. entsprechend abzulängen, an dem bzw. auf dem es angebracht werden soll. Dies gilt entsprechend für dreidimensionale Ausgestaltungen. Hierbei ist es einerseits möglich, dem Bauelement für sich eine geometrische Form zu geben. Beispielsweise können einzelne Leiterbahnäste 7 durch Durchtrennen des Trägermaterials entlang beidseitig des Erstbereiches angeordneten Trennlinien umgebogen, geknickt oder gerollt werden, um so dem Bauelement eine gewünschte dreidimensionale Form zu verleihen. Dabei ist das elektronische Bauelement 1 vorzugsweise mit einem flexiblen Trägermaterial versehen bzw. als flexible Leiterplatte ausgebildet und/oder ist knickbar oder biegbar. Des Weiteren ist es möglich, beispielsweise durch Durchtrennen des Bauelements entlang mehrerer Trennlinien eine Ausgestaltung im Wesentlichen nach der Ausführungsform gemäß Fig. 7 mit in etwa der Mitte des Bauelements angeordnetem Anschlussbereich und Stammbereich, dem Bauelement durch entsprechendes Einrollen bzw. Biegen der einzelnen Leiterbahnäste, Zweige und/oder Unterzweige, eine gewölbte, runde, halbkugel- oder kugelförmige Form zu geben. Trotz der Variationsmöglichkeit der geometrischen und insbesondere räumlichen Ausgestaltungsmöglichkeiten des erfindungsgemäßen Bauelements bleibt die individuelle Ansteuerbarkeit, vorzugsweise gemäß einer Matrixschaltung, der einzelnen Leuchtmittel erhalten.

Für den Fachmann ersichtlich können die einzelnen im Zusammenhang mit den unterschiedlichen bevorzugten beispielhafte Ausführungsformen beschriebenen Merkmale auch in anderen Ausführungsformen vorgesehen werden oder aber mit diesen kombiniert werden.

Die Erfindung umfasst ebenfalls die genauen oder exakten Ausdrücke, Merkmale, numerischen Werte oder Bereiche usw., wenn vorstehend oder nachfolgend diese Ausdrücke, Merkmale, numerischen Werte oder Bereiche im Zusammenhang mit Ausdrücken wie z.B. "etwa, ca., um, im Wesentlichen, im Allgemeinen, zumindest, mindestens" usw. genannt wurden (also "etwa 3" soll ebenfalls "3" oder "im Wesentlichen radial" soll auch "radial" umfassen). Der Ausdruck "bzw." bedeutet überdies "und/oder".

## Patentansprüche

1. Elektronisches Bauelement (1), aufweisend
ein Trägermaterial (2) und mehrere Leiterbahnen,
wobei das Trägermaterial (2) mehrere Befestigungsbereiche (3) für Leuchtmittel, aufweist, die jeweils über erste Leiterbahnen (4) und zweite Leiterbahnen (5) mit mindestens einem Anschlussbereich (8) verbunden oder verbindbar sind,
wobei erste und/oder zweite Leiterbahnen (4, 5) in dem mindestens einen Anschlussbereich (8) zusammengeführt sind,
wobei mehrere der ersten Leiterbahnen (4) jeweils mindestens einen ersten Leiterbahnastabschnitt (4a) und mindestens einen ersten Leiterbahnstammabschnitt (4b) aufweisen,
wobei mehrere der zweiten Leiterbahnen (5) jeweils mindestens einen zweiten Leiterbahnastabschnitt (5a) und mindestens einen zweiten Leiterbahnstammabschnitt (5b) aufweisen,
wobei erste und/oder zweite Leiterbahnstammabschnitte (4b, 5b) mindestens einen Leiterbahnstammbereich (6) ausbilden,
wobei sich erste und zweite Leiterbahnastabschnitte (4a, 5a) von entlang des Leiterbahnstammbereichs (6) verlaufenden ersten und zweiten Leiterbahnen (4, 5) von diesem Leiterbahnstammbereich (6) und/oder von den jeweiligen ersten und zweiten Leiterbahnstammabschnitten winkelig erstrecken und Leiterbahnäste (7) bilden, wobei ein Leiterbahnast (7) durch wenigstens einen ersten und einen zweiten Leiterbahnastabschnitt (4a, 5a) gebildet ist, und
wobei mindestens ein Befestigungsbereich (3) entlang mindestens eines Leiterbahnastes (7) angeordnet ist.

2. Elektronisches Bauelement (1) nach Anspruch 1,
wobei alle Befestigungsbereiche (3) oder mindestens zwei Befestigungsbereiche (3) entlang eines Leiterbahnastes (7) mit einem den Leiterbahnast (7) bildenden ersten Leiterbahnastabschnitt (4a) mindestens einer ersten Leiterbahn (4) verbunden sind, und/oder
wobei mindestens zwei Befestigungsbereiche (3), vorzugsweise jeder Befestigungsbereich (3) entlang eines Leiterbahnastes (7) mit einer anderen zweiten Leiterbahn (5) verbunden sind.

3. Elektronisches Bauelement (1) nach einem der vorangehenden Ansprüche,
mit einem Trägermaterial (2), das mehrere Befestigungsbereiche (3), insbesondere für Leuchtmittel, aufweist, die jeweils über erste Leiterbahnen (4) und zweite Leiterbahnen (5) mit mindestens einem Anschlussbereich (8) verbunden sind,
wobei erste und zweite Leiterbahnen (4, 5) mittels vorzugsweise im Wesentlichen eng beanstandet und/oder im Wesentlichen parallel zueinander verlaufenden ersten und zweiten Leiterbahnabschnitten bzw. Leiterbahnastabschnitten (4a, 5a) mehrere Leiterbahnäste (7) ausbilden,
wobei mehrere Befestigungsbereiche (3) eines Leiterbahnastes (7), vorzugsweise alle Befestigungsbereiche (3), mit einem ersten Leiterbahnastabschnitt (4a) mindestens einer ersten Leiterbahn (4) verbunden sind, und wobei die mehreren Befestigungsbereiche (3), vorzugsweise jeder Befestigungsbereich (3), mit jeweils einer anderen zweiten Leiterbahn (5) verbunden sind
wobei mehrere zweite Leiterbahnen (5) jeweils mindestens zwei Leiterbahnastabschnitte (5a) der mehreren Leiterbahnäste (7) ausbilden und/oder wobei mehrere zweite Leiterbahnen (5) jeweils mit einem Befestigungsbereich (3) verschiedener Leiterbahnastabschnitte (5a) der mehreren Leiterbahnäste (7) verbunden sind.

4. Elektronisches Bauelement (1) nach einem der vorangehenden Ansprüche,
wobei mindestens ein Leiterbahnast (7) mindestens einen Leiterbahnzweig (9) aufweist und/oder sich in mindestens zwei Leiterbahnzweige (9) aufteilt,
wobei entlang der Leiterbahnzweige (9) Befestigungsbereiche (3), bevorzugt jeweils mindestens ein Befestigungsbereich (3) pro Leiterbahnzweig (9), angeordnet sind,
wobei der Leiterbahnast (7) erste und zweite Leiterbahnen (4, 5) bzw. erste und zweite Leiterbahnastabschnitte (4a, 5a) umfasst, die ferner erste und zweite Leiterbahnzweigabschnitte (4c, 5c) aufweisen, und
wobei ein Leiterbahnzweig (9) durch wenigstens einen ersten und einen zweiten Leiterbahnzweigabschnitt (4c, 5c) gebildet ist.

5. Elektronisches Bauelement (1) nach Anspruch 4, wobei Befestigungsbereiche (3) entlang eines Leiterbahnzweiges (9) mit einem den Leiterbahnzweig (9) bildenden ersten Leiterbahnzweigabschnitt (4c) mindestens einer ersten Leiterbahn (4) verbunden sind, und wobei diese Befestigungsbereiche (3) jeweils mit einem zweiten Leiterbahnzweigabschnitt (5c) einer zweiten Leiterbahn (5) des Leiterbahnzweiges (9) verbunden sind.

6. Elektronisches Bauelement (1) nach Anspruch 4 oder 5, wobei mindestens zwei Befestigungsbereiche (3), vorzugsweise alle Befestigungsbereiche (3), entlang eines Leiterbahnzweiges (9) mit einem den Leiterbahnzweig (9) bildenden ersten Leiterbahnzweigabschnitt (4c) mindestens einer ersten Leiterbahn (4) verbunden sind, und/oder
wobei mindestens zwei Befestigungsbereiche (3), vorzugsweise jeder Befestigungsbereich (3), eines Leiterbahnzweiges (9) mit einer anderen zweiten Leiterbahn (5) verbunden sind/ist.

7. Elektronisches Bauelement (1) nach einem der vorangehenden Ansprüche, wobei Leiterbahnzweige (9) entsprechend ausgebildete Leiterbahnunterzweige (9i) aufweisen.

8. Elektronisches Bauelement (1) nach einem der vorangehenden Ansprüche,
wobei das elektronische Bauelement (1) in der Mitte, im Randbereich, und/oder im Eckbereich des Trägermaterials (2) mindestens einen Leiterbahnstammbereich (6) und/oder einen Anschlussbereich (8), und/oder mindestens einen Chip aufweist.

9. Elektronisches Bauelement (1) nach einem der vorangehenden Ansprüche,
wobei das Trägermaterial (2) mindestens einen Trennbereich (10) mit mindestens einer sich entlang dieses Bereichs erstreckenden Trennlinie (13) aufweist, der zwischen benachbarten Leiterbahnästen (7) und/oder Leiterbahnzweigen (9) und/oder Leiterbahnunterzweigen (9i) angeordnet ist, und wobei das Trägermaterial (2) in dem mindestens einen Trennbereich (10) keine Leiterbahn aufweist.

10. Elektronisches Bauelement (1) nach einem der vorangegangenen Ansprüche, wobei das Trägermaterial (2) mindestens einen Ablängbereich (11), aufweist, der entlang mindestens eines Leiterbahnastes (7) und/oder Leiterbahnzweiges (9) und/oder Leiterbahnunterzweiges (9i) angeordnet ist und diesen zumindest teilweise umfasst, wobei der Ablängbereich (11) seitlich durch mindestens einen Trennbereich (10), den Rand des Trägermaterials (2) und/oder eine Ablänglinie (14), die mindestens eine erste und eine zweite Leiterbahn (4, 5) schneidet, begrenzt ist, und
wobei der mindestens eine Ablängbereich (11) derart separierbar ist, dass die ersten und zweiten Leiterbahnen (4, 5) der Leiterbahnäste (7) und/oder Leiterbahnzweige (9) und/oder Leiterbahnunterzweige (9i) des elektronischen Bauelements (1) weiterhin mit einem Anschlusselement (8) verbunden sind.

11. Elektronisches Bauelement (1) nach einem der vorangehenden Ansprüche,
wobei in einem Befestigungsbereich (3) mindestens ein, bevorzugt drei, Leuchtmittel, vorzugsweise LED, vorgesehen sind, und/oder wobei das elektronische Bauelement (1) zumindest teilweise matrixartig ansteuerbar ist.

12. Elektronisches Bauelement (1) nach einem der vorangehenden Ansprüche,
wobei jedes Leuchtmittel eines Befestigungsbereiches (3) an mit dem jeweiligen Befestigungsbereich (3) in Verbindung stehende(n) zweite(n) Leiterbahn(en) (5) angeschlossen ist, und
wobei gleichzeitig jedes Leuchtmittel eines Befestigungsbereiches (3) jeweils an genau eine erste Leiterbahn (4) angeschlossen ist, so dass jede erste mit dem Befestigungsbereich (3) verbundene Leiterbahn (4) genau einem Leuchtmittel des Befestigungsbereichs (3) zugeordnet ist.

13. Elektronisches Bauelement (1) einem der vorangehenden Ansprüche,
wobei die Befestigungsbereiche (3) auf dem Trägermaterial (2) in Zeilen (Zi) und Spalten (Si) unterteilt sind und/oder zeilen- und spaltenweise ansteuerbar sind, und
wobei die Befestigungsbereiche (3) derart angeordnet sind, dass die Befestigungsbereiche (3) einer Spalte (Si) mit der gleichen zweiten Leiterbahn (5) verbunden sind, und/oder dass die Befestigungsbereiche (3) einer Zeile (Zi) mit dergleichen mindestens einen ersten Leiterbahn (4) verbunden sind.

14. Elektronisches Bauelement (1) nach einem der vorangehenden Ansprüche, wobei mindestens zwei der ersten und/oder zweiten Leiterbahnen (4, 5) mindestens abschnittsweise in verschiedenen Ebenen angeordnet sind, und/oder wobei mindestens eine der ersten und zweiten Leiterbahnen (4, 5) mindestens abschnittsweise eine im Vergleich zu anderen Bereichen der ersten und/oder zweiten Leiterbahnen (4, 5) eine gesteigerte Leiterbahnbreite aufweist.

15. Verfahren zur Herstellung eines geometrisch individualisierten elektronischen Bauelementes, oder eines geometrisch individualisierten System von elektronischen Bauelementen, umfassend folgende Schritte:
Bereitstellen von mindestens einem elektronischen Bauelement nach einem der vorangegangenen Ansprüche, und
Anpassen des mindestens einen elektronischen Bauelements an eine gewünschte individuelle Bauteilgeometrie durch Kombination mehrerer elektronischer Bauelemente und/oder Umformung des Bauelement-Trägermaterials;
umfassend das Durchtrennen von Bereichen des Bauelements entlang einer oder mehrerer Trennlinien und/oder Separation von mindestens einem Ablängbereich umfassend mindestens einen Befestigungsbereich.

## Claims

1. Electronic component (1) comprising
a carrier substrate (2) and multiple conductor paths,
wherein the carrier substrate (2) comprises multiple fixing portions (3) for lamps each being connected or being connectable to at least one connecting portion (8) via first conductor paths (4) and second conductor paths (5),
wherein first and/or second conductor paths (4, 5) are brought together in the at least one connecting portion (8),
wherein several of the first conductor paths (4) each comprise at least one first conductor path branch portion (4a) and at least one first conductor path trunk portion (4b),
wherein several of the second conductor paths (5) each comprise at least one second conductor path branch portion (5a) and at least one second conductor path trunk portion (5b),
wherein first and/or second conductor path trunk portions (4b, 5b) form at least one conductor path trunk region (6),
wherein first and second conductor path branch portions (4a, 5a) extend angularly from first and second conductor paths (4, 5) of said conductor path trunk region (6), said first and second conductor paths (4, 5) extending along the conductive trunk region (6), and/or from the respective first and second conductor path trunk portions and form conductor path branches (7),
wherein a conductor path branch (7) is formed by at least one first and one second conductor path branch portion (4a, 5a), and
wherein at least one fixing portion (3) is arranged along at least one conductor path branch (7).

2. The electronic component (1) according to claim 1,
wherein all fixing portions (3) or at least two fixing portions (3) along a conductor path branch (7) are connected to a first conductor path branch portion (4a) of at least a first conductor path (4), said first conductor path branch portion (4a) forming the conductor path branch (7),
and/or
wherein at least two fixing portions (3), preferably each fixing portion (3), along a conductor path branch (7) is connected to another second conductor path (5).

3. The electronic component (1) according to any of the preceding claims,
having a carrier substrate (2) comprising multiple fixing portions (3), particularly for lamps, each of which being connected to at least one connecting portion (8) via first conductor paths (4) and second conductor paths (5),
wherein first and second conductor paths (4, 5) form multiple conductor path branches (7) by means of first and second conductor path portions or conductor path branch portions (4a, 5a) preferably having a substantially small distance to each other and/or running substantially parallel to each other,
wherein multiple fixing portions (3), preferably all fixing portions (3), of a conductor path branch (7) are connected to a first conductor path branch portion (4a) of at least one first conductor path (4), and wherein the multiple fixing portions (3), preferably each fixing portion (3), are each connected to another second conductor path (5),
wherein multiple second conductor paths (5) each form at last two conductor path branch portions (5a) of the multiple conductor path branches (7) and/or wherein multiple second conductor paths (5) each are connected to a fixing portion (3) of various conductor path branch portions (5a) of the multiple conductor path branches (7).

4. The electronic component (1) according to any of the preceding claims,
wherein at least one conductor path branch (7) comprises at least one conductor path twig (9) and/or divides into at least two conductor path twigs (9),
wherein fixing portions (3) are arranged along the conductor path twigs (9), preferably at least one fixing portion (3) at each conductor path twig (9),
wherein the conductor path branch (7) comprises first and second conductor paths (4, 5) or first and second conductor path branch portions (4a, 5a) which further comprise first and second conductor path twig portions (4c, 5c), and
wherein a conductor path twig (9) is formed by at least one first and one second conductor path twig portions (4c, 5c).

5. The electronic component (1) according to claim 4, wherein fixing portions (3) along a conductor path twig (9) are connected to a first conductor path twig portion (4c) of at least one first conductor path (4), said first conductor path twig portion (4c) forming the conductor path twig (9) and wherein said fixing portions (3) are each connected to a second conductor path twig portion (5c) of a second conductor path (5) of the conductor path twig (9).

6. The electronic component (1) according to claim 4 or 5, wherein at least two fixing portions (3), preferably all fixing portions (3), along a conductor path twig (9) are connected to a first conductor path twig portion (4c) of at least one first conductor path (4), said first conductor path twig portion (4c) forming the conductor path twig (9) and/or
wherein at least two fixing portions (3), preferably each fixing portion (3), of a conductor path twig (9) are/is connected to another second conductor path (5).

7. The electronic component (1) according to any of the preceding claims, wherein conductor path twigs (9) comprise correspondingly formed conductor path sub-twigs (9i).

8. The electronic component (1) according to any of the preceding claims,
wherein the electronic component (1) comprises at least one conductor path trunk portion (6) and/or a connecting portion (8) and/or at least one chip in the middle, in the edge region and/or in the corner region of the carrier substrate (2).

9. The electronic component (1) according to any of the preceding claims,
wherein the carrier substrate (2) comprises a partition portion (10) having at least one partition line (13) extending along said portion, the partition portion (10) being arranged between adjacent conductor path branches (7) and/or conductor path twigs (9) and/or conductor path sub-twigs (9i), and wherein the carrier substrate (2) comprises no conductor paths within the at least one partition portion (10).

10. The electronic component (1) according to any of the preceding claims, wherein the carrier substrate (2) comprises at least one trimming region (11) being arranged along and at least partially encompassing at least one conductor path branch (7) and/or one conductor path twig (9) and/or one conductor path sub-twig (9i),
wherein the trimming region (11) is limited laterally by at least one partition portion (10), the edge of the carrier substrate (2) and/or a trimming line (14) intersecting with at least one first and one second conductor path (4, 5), and
wherein the at least one trimming region (11) can be separated such that the first and second conductor paths (4, 5) of the conductor path branches (7) and/or the conductor path twigs (9) and/or the conductor path sub-twigs (9i) of the electronic component (1) are still connected to a connecting element (8).

11. The electronic component (1) according to any of the preceding claims,
wherein in a fixing portion (3) at least one, preferably three, lamp(s), preferably LED(s), is(are) arranged and/or wherein the electronic component (1) can be controlled at least partially in a matrix-like manner.

12. The electronic component (1) according to any of the preceding claims,
wherein each lamp of a fixing portion (3) is connected to second conductor path(s) (5) connected to the respective fixing portion (3), and
wherein simultaneously each lamp of a fixing portion (3) is connected to exactly one first conductor path (4) so that each first conductor path (4) connected to the fixing portion (3) is associated to exactly one lamp of the fixing portion (3).

13. The electronic component (1) of any of the preceding claims,
wherein the fixing portions (3) on the carrier substrate (2) are divided into lines (Zi) and columns (Si) and/or can be controlled in a line-wise or column-wise manner, and
wherein the fixing portions (3) are arranged such that the fixing portions (3) of a column (Si) are connected to the same second conductor path (5) and/or that the fixing portions (3) of a line (Zi) are connected to the same at least one first conductor path (4).

14. The electronic component (1) according to any of the preceding claims, wherein at least two of the first and/or second conductor paths (4, 5) are arranged at least in sections in different planes, and/or
wherein at least one of the first and second conductor paths (4, 5) comprises at least in sections an increased conductor path width compared to other portions of the first and/or second conductor paths (4. 5).

15. Method for manufacturing a geometrically individualized electronic component or a geometrically individualized system of electronic components comprising the following steps:
providing at least one electronic component according to any of the preceding claims, and
adapting the at least one electronic component to a desired individual component geometry by combining multiple electronic components and/or by re-shaping the carrier substrate of the component;
comprising the cutting of portions of the component along one or more partition lines and/or separating at least one trimming region comprising at least one fixing portion.

## Revendications

1. Composant électronique (1), comprenant
un matériau support (2) et plusieurs pistes conductrices,
où le matériau support (2) comporte plusieurs zones de fixation (3) pour des sources d'éclairage, lesquelles sont reliées ou susceptibles d'être reliées chacune par de premières pistes conductrices (4) et de deuxièmes pistes conductrices (5) à au moins une zone de connexion (8),
où des premières et/ou des deuxièmes pistes conductrices (4, 5) sont réunies dans la ou les zones de connexion (8),
où plusieurs des premières pistes conductrices (4) présentent chacune au moins un premier segment de branche de piste conductrice (4a) et au moins un premier segment de tronc de piste conductrice (4b),
où plusieurs deuxièmes pistes conductrices (5) présentent chacune au moins un deuxième segment de branche de piste conductrice (5a) et au moins un deuxième segment de tronc de piste conductrice (5b),
où des premiers et/ou des deuxièmes segments de tronc de piste conductrice (4b, 5b) forment au moins une zone de tronc de piste conductrice (6),
où des premiers et des deuxièmes segments de branche de piste conductrice (4a, 5a) s'étendent angulairement à partir de premières et deuxièmes pistes conductrices (4, 5) de la zone de tronc de piste conductrice (6), lesdites premières et deuxièmes pistes conductrices (4, 5) cheminant le long de ladite zone de tronc de piste conductrice (6), et/ou à partir des premiers et deuxièmes segments de tronc de piste conductrice respectifs et forment des branches de piste conductrice (7),
où une branche de piste conductrice (7) est formée par au moins un premier et un deuxième segment de branche de piste conductrice (4a, 5a), et
où au moins une zone de fixation (3) est située le long d'au moins une branche de piste conductrice (7).

2. Composant électronique (1) selon la revendication 1,
où toutes les zones de fixation (3) ou au moins deux zones de fixation (3) le long d'une branche de piste conductrice (7) sont reliées à un premier segment de branche de piste conductrice (4a) d'au moins une première piste conductrice (4), ledit premier segment de branche de piste conductrice (4a) formant la branche de piste conductrice (7), et/ou
où au moins deux zones de fixation (3), préférentiellement chaque zone de fixation (3) le long d'une branche de piste conductrice (7), est/sont reliée(s) à une autre deuxième piste conductrice (5).

3. Composant électronique (1) selon l'une des revendications précédentes,
avec un matériau support (2) comportant plusieurs zones de fixation (3), en particulier pour des sources d'éclairage, lesquelles sont reliées chacune par de premières pistes conductrices (4) et de deuxièmes pistes conductrices (5) à au moins une zone de connexion (8),
où les premières et les deuxièmes pistes conductrices (4, 5) forment plusieurs branches de piste conductrice (7) au moyen de premiers et de deuxièmes segments de piste conductrice ou segments de branche de piste conductrice (4a, 5a) préférentiellement sensiblement étroitement rapprochés et/ou sensiblement parallèles entre eux,
où plusieurs zones de fixation (3) d'une branche de piste conductrice (7), préférentiellement toutes les zones de fixation (3), sont reliées à un premier segment de branche de piste conductrice (4a) d'au moins une première piste conductrice (4), et où les plusieurs zones de fixation (3), préférentiellement chaque zone de fixation (3), est/sont reliée(s) à une autre deuxième piste conductrice (5),
où plusieurs deuxièmes pistes conductrices (5) forment chacune au moins deux segments de branche de piste conductrice (5a) des plusieurs branches de piste conductrice (7) et/ou où plusieurs deuxièmes pistes conductrices (5) sont reliées chacune à une zone de fixation (3) de différents segments de branche de piste conductrice (5a) des plusieurs branches de piste conductrice (7).

4. Composant électronique (1) selon l'une des revendications précédentes,
où au moins une branche de piste conductrice (7) comporte au moins un rameau de piste conductrice (9) et/ou se divise en au moins deux rameaux de piste conductrice (9), où des zones de fixation (3), préférentiellement au moins une zone de fixation (3) par rameau de piste conductrice (9), sont disposées le long des rameaux de piste conductrice (9),
où la branche de piste conductrice (7) comprend des premières et des deuxièmes pistes conductrices (4, 5) ou des premiers et des deuxièmes segments de branche de piste conductrice (4a, 5a), lesquels comportent en outre de premiers et deuxièmes segments de rameau de piste conductrice (4c, 5c), et
où un rameau de piste conductrice (9) est formé par au moins un premier et un deuxième segments de rameau de piste conductrice (4c, 5c).

5. Composant électronique (1) selon la revendication 4, où des zones de fixation (3) le long d'un rameau de piste conductrice (9) sont reliés à un premier segment de rameau de piste conductrice (4c) d'au moins une première piste conductrice (4), lequel forme le rameau de piste conductrice (9), et où lesdites zones de fixation (3) sont reliées chacune à un deuxième segment de rameau de piste conductrice (5c) d'une deuxième piste conductrice (5) du rameau de piste conductrice (9).

6. Composant électronique (1) selon la revendication 4 ou la revendication 5, où au moins deux zones de fixation (3), préférentiellement toutes les zones de fixation (3) le long d'un rameau de piste conductrice (9) sont reliées à un premier segment de rameau de piste conductrice (4c) d'au moins une première piste conductrice (4), lequel forme la rameau de piste conductrice (9), et/ou
où au moins deux zones de fixation (3), préférentiellement chaque zone de fixation (3), d'un rameau de piste conductrice (9) est/sont reliée(s) à une autre deuxième piste conductrice (5).

7. Composant électronique (1) selon l'une des revendications précédentes, où des rameaux de piste conductrice (9) comportent des sous-rameaux de piste conductrice (9i) réalisés en conséquence.

8. Composant électronique (1) selon l'une des revendications précédentes,
où ledit composant électronique (1) comporte au centre, dans la zone de bordure, et/ou dans la zone de coin du matériau support (2) au moins une zone de tronc de piste conductrice (6) et/ou une zone de connexion (8), et/ou au moins une puce.

9. Composant électronique (1) selon l'une des revendications précédentes,
où le matériau support (2) comporte au moins une zone de séparation (10) avec au moins une ligne de séparation (13) qui s'étend le long de cette zone, laquelle est disposée entre branches de piste conductrice (7) et/ou rameaux de piste conductrice (9) et/ou sous-rameaux de piste conductrice (9i) contigus, et où le matériau support (2) ne présente aucune piste conductrice dans la ou les zones de séparation (10).

10. Composant électronique (1) selon l'une des revendications précédentes, où le matériau support (2) présente au moins une zone de sectionnement (11), située le long d'au moins une branche de piste conductrice (7) et/ou d'un rameau de piste conductrice (9) et/ou d'un sous-rameau de piste conductrice (9i) et comprenant au moins partiellement celui-ci, la zone de sectionnement (11) étant latéralement délimitée par au moins une zone de séparation (10), le bord du matériau support (2) et/ou une ligne de sectionnement (14) qui croise au moins une première et une deuxième piste conductrice (4, 5), et
où la ou les zones de sectionnement (11) sont séparables de telle manière que les premières et deuxièmes pistes conductrices (4, 5) des branches de piste conductrice (7) et/ou des rameaux de piste conductrice (9) et/ou des sous-rameaux de piste conductrice (9i) du composant électronique (1) restent reliées à un élément de connexion (8).

11. Composant électronique (1) selon l'une des revendications précédentes,
où au moins une, préférentiellement trois sources d'éclairage, préférentiellement des LED, sont prévues dans une zone de fixation (3), et/ou où le composant électronique (1) peut être commandé dans une manière au moins partiellement matricielle.

12. Composant électronique (1) selon l'une des revendications précédentes,
où chaque source d'éclairage d'une zone de fixation (3) est connectée à la/aux deuxième(s) piste(s) conductrice(s) (5) reliée(s) à la zone de fixation (3) respective, et
où chaque source d'éclairage d'une zone de fixation (3) est simultanément connectée à une seule première piste conductrice (4), de telle manière que chaque première piste conductrice (4) reliée à la zone de fixation (3) est affectée à une seule source d'éclairage de la zone de fixation (3).

13. Composant électronique (1) selon l'une des revendications précédentes,
où les zones de fixation (3) sur le matériau support (2) sont subdivisées en rangées (Zi) et en colonnes (Si) et/ou peuvent être commandées par rangées et par colonnes, et où les zones de fixation (3) sont disposées de telle manière que les zones de fixation (3) d'une colonne (Si) sont reliées à la même deuxième piste conductrice (5), et/ou en ce que les zones de fixation (3) d'une rangée (Zi) sont reliées à la même ou aux mêmes premières pistes conductrices (4).

14. Composant électronique (1) selon l'une des revendications précédentes, où au moins deux des premières et/ou des deuxièmes pistes conductrices (4, 5) sont disposées au moins en partie sur des plans différents, et/ou où au moins une des premières et des deuxièmes pistes conductrices (4, 5) présente au moins en partie une largeur de piste conductrice augmentée par rapport à d'autre zones des premières et/ou des deuxièmes pistes conductrices (4, 5).

15. Procédé de fabrication d'un composant électronique géométriquement individualisé, ou d'un système de composants électroniques géométriquement individualisé, comprenant les étapes suivantes :
préparation d'au moins un composant électronique selon l'une des revendications précédentes, et
ajustement du ou des composants électroniques à une géométrie individuelle de pièce souhaitée par combinaison de plusieurs composants électroniques et/ou déformation du matériau support de composant ;
incluant le sectionnement de zones du composant le long d'une ou de plusieurs lignes de séparation et/ou la séparation d'au moins une zone de sectionnement comprenant au moins une zone de fixation.
